(19) Europäisches Patentamt / European Patent Office / Office européen des brevets

(11) **EP 2 609 704 B1**

(12) **FASCICULE DE BREVET EUROPEEN**

(45) Date de publication et mention de la délivrance du brevet:
**05.10.2016 Bulletin 2016/40**

(21) Numéro de dépôt: **11761679.7**

(22) Date de dépôt: **29.08.2011**

(51) Int Cl.:
*H03M 13/05* (2006.01)   *H04L 25/03* (2006.01)
*H04L 25/497* (2006.01)   *H04L 1/06* (2006.01)
*H04L 1/00* (2006.01)   *H04B 7/04* (2006.01)

(86) Numéro de dépôt international:
**PCT/FR2011/051977**

(87) Numéro de publication internationale:
**WO 2012/042140 (05.04.2012 Gazette 2012/14)**

(54) **PROCEDE ET DISPOSITIF D'EMISSION ET DE RECEPTION DANS UN CANAL À PLUSIEURS ENTRÉES ET SORTIES RÉPARTISSANT UN MOT DE CODE ENTRE PLUSIEURS MATRICES DE MAPPAGE, ET PROGRAMME D'ORDINATEUR CORRESPONDANTS**

VERFAHREN UND VORRICHTUNG FÜR ÜBERTRAGUNG UND EMPFANG IN EINEM MIMO-KANAL, VERTEILUNG EINES CODEWORTES ZWISCHEN MEHREREN ZUORDNUNGSMATRIZEN UND ZUGEHÖRIGES COMPUTERPROGRAMM

METHOD AND DEVICE FOR TRANSMISSION AND RECEPTION IN A MULTI-INPUT MULTI-OUTPUT CHANNEL, DISTRIBUTING A CODE WORD BETWEEN MULTIPLE MAPPING MATRICES, AND CORRESPONDING COMPUTER PROGRAM

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **27.08.2010 FR 1056819**

(43) Date de publication de la demande:
**03.07.2013 Bulletin 2013/27**

(73) Titulaire: **Orange**
**75015 Paris (FR)**

(72) Inventeurs:
• **CARLACH, Jean-Claude**
  **F-35000 Rennes (FR)**
• **EL ARAB, Ali**
  **F-35830 Betton (FR)**
• **HELARD, Maryline**
  **F-35700 Rennes (FR)**

(74) Mandataire: **Vidon Brevets & Stratégie**
**16B, rue de Jouanet**
**B.P. 90333**
**Technopole Atalante**
**35703 Rennes Cedex 7 (FR)**

(56) Documents cités:
• **CHANG-KYUNG SUNG ET AL: "Quasi-orthogonal STBC with iterative decoding in bit interleaved coded modulation", 2004 IEEE 60TH VEHICULAR TECHNOLOGY CONFERENCE. VTC2004-FALL (IEEE CAT. NO.04CH37575) IEEE PISCATAWAY, NJ, USA,, vol. 2, 26 septembre 2004 (2004-09-26), pages 1323-1327, XP010786839, DOI: DOI:10.1109/VETECF.2004.1400238 ISBN: 978-0-7803-8521-4**
• **BOLCSKEI H ET AL: "Noncoherent Space-Frequency Coded MIMO-OFDM", IEEE JOURNAL ON SELECTED AREAS IN COMMUNICATIONS, IEEE SERVICE CENTER, PISCATAWAY, US, vol. 23, no. 9, 1 septembre 2005 (2005-09-01), pages 1799-1810, XP011138715, ISSN: 0733-8716, DOI: DOI:10.1109/JSAC.2005.853800**

**Description**

**1. Domaine de l'invention**

Le domaine de l'invention est celui des communications numériques.

Plus précisément, l'invention concerne la transmission de données par communications radio-électriques, ou communications radio, et plus particulièrement les systèmes de transmission radio à plusieurs antennes d'émission et plusieurs antennes de réception, dits "MIMO" (en anglais « Multi-Input Multi-Output »).

L'invention trouve notamment des applications dans les réseaux radio numériques comme les systèmes GSM ou UMTS ou les réseaux radio WiFi, et aussi dans les futurs systèmes de communications selon les futures normes 4G, LTE ou entre véhicules, objets ou machines communicants...

L'invention trouve également des applications dans les systèmes de transmission de données numériques sur câbles électriques comme dans les systèmes ADSL ou système CPL sur les câbles d'alimentation électrique soumis à des interférences multiples entre des communications transmises sur des câbles voisins.

L'invention peut également être appliquée aux systèmes utilisant la technique de filtrage spatio-temporel de formation de faisceaux ou lobes d'antennes ("BeamForming" en anglais) et aux systèmes utilisant la technique de renversement temporel de la réponse du canal ("time-reversal" en anglais).

**2. Art antérieur**

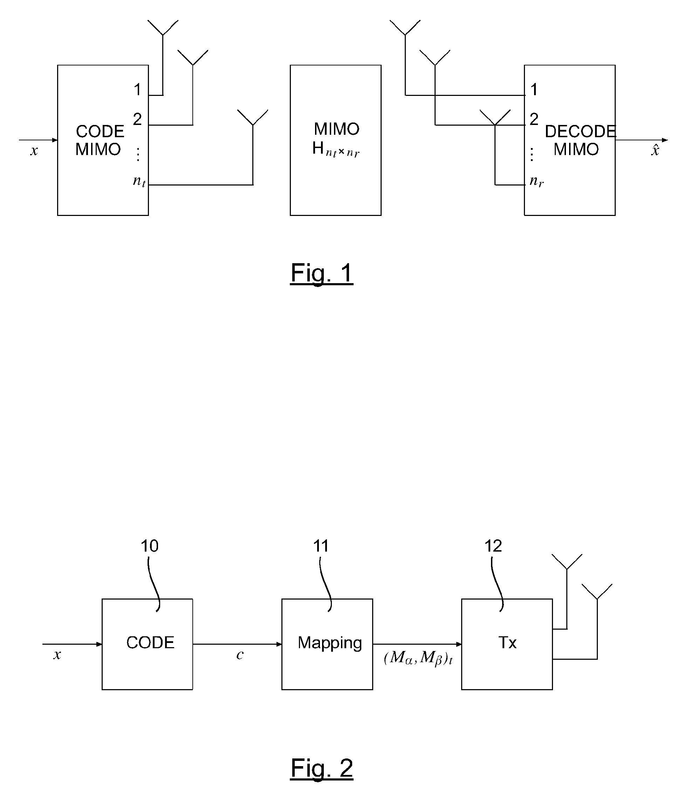

On connaît plusieurs types de techniques MIMO, dont le schéma général est illustré en figure 1, pour un signal émis $x$ et un signal reçu $\hat{x}$ et avec $n_t$ antennes d'émission, $n_r$ antennes de réception et une matrice de canal MIMO notée $H_{n_t \times n_r}$.

Le document "Quasi orthogonal STBC with iterative decoding in bit interleaved coded modulation" de Chang-Kyung Sung, VTC 2004, pp 1323-1327, divulgue en section II et Figure 1, un système effectuant un codage canal de données à transmettre, les entrelaçant, et les envoyant en parallèle à différents modules de mappage avant qu'un codage de type espace / temps ne soit réalisé.

L'objectif initial des techniques MIMO est d'exploiter la diversité spatiale et temporelle (ou fréquentielle) des systèmes multi-antennes et d'améliorer la capacité de ceux-ci.

En revanche, la fonction de correction des erreurs, encore appelée décodage de canal, n'est prise en compte que depuis peu dans la construction des codes espace-temps MIMO, comme décrit dans le document *« M.S. Hassan, K. Amis, "Turbo-Product Codes Decoding for Concatenated Space-Time Error-Correcting Codes ", 20th International Symposium PIMRC'2009, pp.1049-1053, 13-16 Septembre 2009 ».*

Certaines de ces techniques MIMO, dites "cohérentes", nécessitent une connaissance parfaite du canal à l'émission ou à la réception, et d'autres de ces techniques, dites "non-cohérentes", ne nécessitent pas de connaissance du canal, ni à l'émission ni à la réception.

Parmi les techniques MIMO cohérentes, on trouve notamment deux familles : les techniques de type « STBC » (pour « Space-Time Block Codes » en anglais) et les techniques de type « STTC » ( pour « Space-Time Trellis Codes » en anglais).

Les techniques MIMO non-cohérentes existantes mettent en oeuvre des codages par bloc adaptés de ces techniques cohérentes STBC ou STTC précédemment citées. Ces techniques MIMO non-cohérentes correspondent en fait à une extension, au cas MIMO, de la technique différentielle utilisée pour les systèmes différentiels SISO (« Single-Input Single-Output » : cas classique à une seule antenne en émission et en réception).

Le principe de base des codes différentiels est le suivant : le symbole transmis à l'instant $(t)$ est égal au symbole transmis à l'instant $(t-1)$ multiplié par une matrice $Vt$ complexe ou un simple complexe porteur de l'information. L'information à transmettre est donc codée par la transition d'un symbole à un autre et non par la valeur ou l'état de chaque symbole.

L'hypothèse de base pour cette technique différentielle est que le canal est supposé constant pendant un long bloc de données (au moins plusieurs centaines) à transmettre.

La solution la plus simple pour étendre ces codes différentiels au cas MIMO est d'utiliser des codes espace-temps orthogonaux car ils permettent de générer des canaux virtuels SISO parfaitement orthogonaux dans le canal MIMO et ainsi de pouvoir effectuer un codage différentiel sur chaque canal virtuel. Il en existe plusieurs exemples dans la littérature, certains d'entre eux sont notamment présentés dans le document *«Codes Design for Non-Coherent MIMO-OFDM Systems » de H.Bölckei et M. Borgmann, Allerton Conference 2002, pp. 237-246 ».*

Ces techniques différentielles MIMO, non cohérentes, ne mettent cependant en oeuvre aucune correction d'erreur et ne présentent donc pas de gain de codage. Leur unique objectif est de permettre la détection des données transmises sans connaissance du canal de propagation.

Un premier inconvénient de ces techniques réside dans une perte de performance de 3dB par rapport aux transmissions avec connaissance du canal de propagation, au moins en partie du fait de l'absence de gain de codage due à l'absence de codage correcteur d'erreurs.

Une solution pour présenter un gain de codage pour ces techniques différentielles est de les combiner avec un codage correcteur d'erreurs sous forme de deux fonctions disjointes. Les performances sont alors améliorées mais la perte de 3dB au niveau de la détection différentielle ne peut être compensée. Pour tenter de palier cet inconvénient, certaines études ont été menées afin de mettre en place une réception itérative, comme présenté par exemple dans le document « B.L. Hughes, "Differential Space-Time Modulation ", IEEE transactions on Information Theory, vol-46, no.7, pages 2567-2578, November 2000 ». Cette réception itérative permet de faire communiquer les deux fonctions de détection et correction d'erreurs de manière successive et itérative par échange d'information extrinsèque entre les deux fonctions, afin de pouvoir réduire, seulement en partie, cette perte de 3dB issue de la détection différentielle.

Cependant, l'inconvénient principal de ces techniques différentielles réside dans la nécessité de supposer le canal constant pendant un long bloc de données à transmettre, qui est l'hypothèse de base de ces techniques. Cette hypothèse est en effet très contraignante et peu réaliste, notamment pour les canaux radio-électriques utilisés en pratique pour des transmissions vers et depuis des terminaux mobiles.

Il existe donc un besoin pour une nouvelle technique de transmission de données MIMO non-cohérente permettant de s'affranchir de la contrainte supposant le canal constant pendant un long bloc de données à transmettre et offrant de meilleures performances en termes de débit de transmission et/ou de qualité de service pour les clients.

## 3. Exposé de l'invention

L'invention propose une solution nouvelle qui ne présente pas l'ensemble de ces inconvénients de l'art antérieur, sous la forme d'un procédé d'émission d'une séquence binaire source comprenant au moins un mot source x, dans un canal de transmission selon la revendication indépendante 1.

Selon l'invention, un tel procédé d'émission comprend les étapes suivantes, pour au moins un mot source :

- codage correcteur d'erreurs du mot source x, délivrant un mot de code *c ;*
- répartition des bits composant le mot de code c dans au moins deux matrices appelées matrices de mappage, inversibles et respectant un critère d'unicité de l'annulation du syndrome associé au mot de code c, ladite étape de répartition étant appelée étape de mappage matriciel ;
- émission successive des deux matrices de mappage.

Ainsi, l'invention repose sur une approche nouvelle et inventive de la transmission de données source dans un canal de transmission, permettant une transmission plus robuste et plus performante, sans nécessiter de connaissance de canal, en combinant une nouvelle modulation matricielle à un codage correcteur d'erreurs.

Pour ce faire, dans un premier temps, l'invention applique, à au moins un mot source, un codage correcteur d'erreurs, et délivre un mot de code.

Dans un deuxième temps, l'invention met en oeuvre un mappage, ou une correspondance, du mot de code délivré, permettant de répartir les bits de ce mot de code dans au moins deux matrices spécifiques, dites matrices de mappage, présentant certaines caractéristiques permettant, au décodage, de reconstruire le mot de code émis avec des performances améliorées par rapport à l'art antérieur, tout en s'affranchissant de la connaissance du canal. Ces caractéristiques sont l'inversibilité et le respect d'un critère d'unicité de l'annulation du syndrome associé au mot de code.

Le choix de matrices inversibles permet d'obtenir une estimée du canal et donc de s'affranchir de la connaissance du canal, comme décrit en Annexe A, faisant partie intégrante de la description.

De plus, la caractéristique de respect d'un critère d'unicité de l'annulation du syndrome permet de s'assurer qu'un unique mot de code, correspondant à un unique couple de matrices de mappage, annule le syndrome, et permet donc de décoder les matrices reçues de manière performante. Ceci est également décrit dans l'Annexe A, et plus en détail dans la suite de la description.

Selon un aspect particulier de l'invention, le critère d'unicité de l'annulation du syndrome s'écrit de la façon suivante, pour une étape de mappage matriciel délivrant deux matrices à émettre $M_{\alpha}$ et $M_{\beta}$ associées au mot de code *c :*

$$M_{\alpha}.M_a^{-1} - M_{\beta}.M_b^{-1} = 0 \,,$$

avec *($M_a$, $M_b$)* un unique couple de matrices correspondant au mot de code *c* dans un cas parfait de canal de transmission constant.

Ainsi, les matrices de mappage $M_{\alpha}$ et $M_{\beta}$ associées au mot de code *c* sont choisies de sorte que, lorsqu'elles sont multipliées respectivement par les matrices inversées de $M_{\alpha}$ et de $M_b$ , la différence des produits s'annule. La matrice $\left[ M_a^{-1}, -M_b^{-1} \right]$ joue le rôle équivalent d'une matrice de contrôle d'un code correcteur d'erreurs. L'algorithme de décodage va donc consister à trouver l'unique couple de matrices $(M_a \, M_b)$ minimisant la norme du syndrome associé au mot de code $c$, parmi l'ensemble des couples $(M_a \, M_b)$ possibles correspondant aux mots de code $c$ possibles émis, comme décrit plus en détail ci-dessous.

Selon un mode de réalisation particulier de l'invention, l'étape de mappage comprend une sous-étape de permutation des bits du mot de code $c$, préalable à la répartition des bits composant le mot de code $c$.

Cette permutation des bits du mot de code permet par exemple de sélectionner des matrices de mappage dans un ensemble connu de matrices.

Par exemple, une configuration de permutations possibles consiste à ne pas permuter les $i$ premiers bits du mot de code de $n$ bits (permutation identité notée $\pi_0$), et à permuter selon une permutation $\pi_1$ les $n$-i derniers bits du mot de code, telle que $(0,1,2,3)$ donne $(0,3,2,1)$.

Par exemple, cette sous-étape de permutation permet de mettre en oeuvre une étape de mappage répartissant au moins quatre bits $(c_0, c_1, c_2, c_3)$ composant le mot de code $c$ dans une matrice de mappage sélectionnée dans un ensemble connu de matrices inversibles à coefficients complexes, noté groupe de Weyl, décrit plus en détail dans la suite de la description.

En particulier, la mise en oeuvre de permutations des bits du mot de code permet de sélectionner une première matrice de mappage dans un premier sous-ensemble de matrices du groupe de Weyl, encore appelé classe latérale ou coset, noté $C_0$, et une deuxième matrice de mappage dans un deuxième sous-ensemble de matrices du groupe de Weyl, noté $C_2$.

Ce mode de réalisation permet de répartir quatre bits du mot de code dans une matrice de mappage et permet notamment d'utiliser un code correcteur d'erreurs de type code en bloc de Hamming (8,4,4) ou code convolutif de Hamming (8,4,4).

Selon un autre mode de réalisation particulier de l'invention, l'étape de mappage répartit au moins huit bits $(c_0, c_1, c_2, ... c_7)$ composant le mot de code $c$ dans une matrice de mappage $A$ et comprend les sous-étapes suivantes :

- mappage selon le mappage de Gray des paires $(c_2,c_3)$, $(c_4,c_5)$ et $(c_6,c_7)$ délivrant un triplet de symboles complexes $(s_0, s_1, s_2)$ ;
- mappage de la paire $(c_0, c_1)$ en insérant le nombre complexe 0 en place $(2c_0+1)$ dans le triplet de symboles complexes délivrant un quadruplet de symboles complexes ;
- répartition des symboles complexes du quadruplet dans une matrice de mappage inversible $A$.

Ainsi, selon ce mode de réalisation, le mappage choisi permet notamment de répartir huit bits du mot de code dans une matrice de mappage et d'utiliser par exemple un code correcteur d'erreurs de type code convolutif de Golay.

De plus, selon ce mode de réalisation, les matrices de mappage peuvent être construites, et non sélectionnées dans un ensemble connu, de façon à être inversibles et à respecter le critère d'unicité de l'annulation du syndrome associé au mot de code.

Selon un aspect particulier de l'invention, qui généralise le mode de réalisation décrit ci-dessus, l'étape de mappage comprend en outre $n$ étapes de répartition d'au moins huit bits composant le mot de code $c$, respectivement dans au moins $n$ matrices de mappage $A_n$, avec $n$ un entier non nul, et le procédé d'émission comprend une étape de calcul d'une matrice de mappage globale à émettre correspondant à la somme $A + \sum_{i=1}^{n} \dfrac{A_i}{2^i}$.

Ainsi, selon le type de mappage choisi, et donc selon les matrices de mappage sélectionnées ou construites, l'étape de mappage permet de répartir seize bits du mot de code dans une seule matrice de mappage, voire même vingt-quatre ou trente deux bits.

L'invention concerne également un dispositif d'émission d'une séquence binaire source comprenant au moins un mot source $x$, dans un canal de transmission selon la revendication indépendante 7.

Selon l'invention, un tel dispositif met en oeuvre, pour au moins un mot source :

- des moyens de codage correcteur d'erreurs du mot source $x$, délivrant un mot de code $c$ ;
- des moyens de répartition des bits composant le mot de code $c$ dans au moins deux matrices appelées matrices de mappage, inversibles et respectant un critère d'unicité de l'annulation du syndrome associé au mot de code $c$, lesdits moyens de répartition étant appelés moyens de mappage matriciel ;
- des moyens d'émission successive desdites au moins deux matrices de mappage. Selon l'invention, un tel dispositif est notamment adapté à mettre en oeuvre le procédé d'émission décrit précédemment.

Ce dispositif d'émission pourra bien sûr comporter les différentes caractéristiques relatives au procédé d'émission selon l'invention. Ainsi, les caractéristiques et avantages de ce dispositif sont les mêmes que ceux du procédé d'émission, et ne sont pas détaillés plus amplement.

Un autre aspect de l'invention concerne un procédé de réception selon la revendication indépendante 8 d'une séquence binaire émise, après passage de la séquence binaire émise dans un canal de transmission, délivrant une séquence binaire reconstruite comprenant au moins un mot reconstruit, la séquence binaire émise étant obtenue à partir d'une séquence binaire comprenant au moins un mot source $x$, ayant subi avant émission les étapes suivantes, pour au moins un mot source $x$ :

- codage correcteur d'erreurs du mot source $x$, délivrant un mot de code $c$ ;
- répartition des bits composant le mot de code $c$ dans au moins deux matrices appelées matrices de mappage, inversibles et respectant un critère d'unicité de l'annulation du syndrome associé au mot de code $c$, ladite étape de répartition étant appelée étape de mappage matriciel ;
- émission successive desdites au moins deux matrices de mappage.

Selon l'invention, un tel procédé de réception comprend les étapes suivantes, pour au moins deux matrices reçues :

- identification d'au moins deux matrices de décodage inversibles à coefficients complexes permettant de respecter un critère de minimisation de la norme du syndrome associé au mot de code $c$ ;
- détermination du mot reconstruit à partir des matrices de décodage identifiées.

Ainsi, l'invention repose sur une approche nouvelle et inventive de la réception et du décodage de données émises dans un canal, ayant subi un traitement à l'émission tel que décrit ci-dessus en relation avec le procédé d'émission selon l'invention, permettant de reconstruire le mot de code émis avec des performances améliorées par rapport à l'art antérieur, tout en s'affranchissant de la connaissance du canal.

En effet, les deux matrices émises selon le procédé d'émission de l'invention étant choisies inversibles et respectant un critère d'unicité de l'annulation du syndrome associé au mot de code $c$, le procédé de réception selon l'invention consiste à trouver l'unique couple de matrices de décodage $(M_a, M_b)$ minimisant la norme du syndrome associé au mot de code $c$, parmi l'ensemble des couples $(M_a, M_b)$ possibles correspondant aux mots de code $c$ possibles émis.

Comme les matrices $M_\alpha$ et $M_\beta$ émises résultent du codage redondant selon le code correcteur d'erreurs choisi à l'émission et du mappage dans un ensemble de matrices inversibles, la recherche de la minimisation du syndrome associé au mot de code $c$ est mise en oeuvre sur l'ensemble des mots de code $c$ possibles et donc sur l'ensemble des mots source $x$ possibles qui ont pour images $(M_a, M_b)(x)$. L'invention permet ainsi de reconstruire le mot source $x$.

Selon un mode de réalisation de l'invention, le critère de minimisation de la norme du syndrome associé au mot de code $c$ s'écrit de la façon suivante, pour deux matrices reçues $Y(t)$ et $Y(t+1)$ et deux matrices de décodage $M_a$ et $M_b$ :

$$(\hat{M}_a, \hat{M}_b) = Arg \min_{(M_a, M_b)} \left\| Y(t).M_a^{-1} - Y(t+1).M_b^{-1} \right\| ,$$

où $\|\cdot\|$ représente la norme d'une matrice.

La norme d'une matrice peut être par exemple la norme de Frobenius, notée $\|\cdot\|_F$ , correspondant à la somme des modules de chacun des coefficients de la matrice.

Selon un aspect particulier de l'invention, le procédé de réception comprend, préalablement à l'étape de détermination du mot reconstruit, les étapes suivantes, pour un codage correcteur d'erreurs mettant en oeuvre un code convolutif représenté en treillis :

- détermination des métriques des branches des sections du treillis du code convolutif, chaque branche étant étiquetée par une des matrices de décodage ;
- mise en oeuvre de l'algorithme de décodage de Viterbi, à partir des métriques de branche, délivrant des métriques d'état.

Ainsi, l'invention prévoit un calcul particulier des métriques de branche des sections en treillis d'une représentation d'un code correcteur d'erreurs de type code convolutif, tenant compte des matrices de décodage, afin d'appliquer ensuite l'algorithme de décodage de Viterbi, de manière classique.

L'utilisation d'un tel code correcteur d'erreurs convolutif permet de produire en série des suites de paquets de bits sous la forme de mots de code, subissant les étapes du procédé d'émission selon l'invention tel que décrit précédemment, et donc d'augmenter la capacité de correction en considérant le canal de transmission comme une suite continue, tout en minimisant la complexité en réception et décodage.

En particulier, une métrique $\gamma_t(M_b)$ d'une des branches étiquetée par une matrice de décodage $M_b$ est déterminée par l'équation suivante, pour trois matrices reçues $Y(t-1)$, $Y(t)$ et $Y(t+1)$ et trois matrices de décodage $M_a$, $M_b$ et $M_c$ :

$$\gamma_t(M_b) = \min_{(M_a, M_c)} \lambda \left\| Y(t-1).M_a^{-1} - 2Y(t).M_b^{-1} + Y(t+1).M_c^{-1} \right\| + \mu \left\| Y(t) - \hat{H}'(t).M_b \right\|,$$

où $\lambda$ et $\mu$ sont des coefficients de pondération adaptatifs et $\hat{H}'(t)$ est une estimée de la matrice de canal après convergence de l'algorithme de décodage de Viterbi telle que :

$$\hat{H}'(t) = \left( Y(t-1).M_a^{-1} + Y(t).M_b^{-1} + Y(t+1).M_c^{-1} \right)/3 .$$

Ainsi, pour calculer une métrique de branche étiquetée par une matrice de décodage $M_b$, on cherche à minimiser le syndrome sur trois éléments, sous la forme d'une dérivée seconde du syndrome décrit ci-dessus, avec en plus des coefficients de pondération $\lambda$ et $\mu$ permettant de fusionner les critères connus de la minimisation de la variation du canal et de la distance euclidienne entre le signal reçu et les signaux possiblement émis connaissant la matrice de canal.

Un autre aspect de l'invention concerne un dispositif de réception selon la revendication indépendante 12 d'une séquence binaire émise, après passage de la séquence binaire émise dans un canal de transmission, délivrant une séquence binaire reconstruite comprenant au moins un mot reconstruit, la séquence binaire émise étant obtenue à partir d'une séquence binaire comprenant au moins un mot source $x$, pour lequel ont été mis en oeuvre, avant émission :

- des moyens de codage correcteur d'erreurs du mot source $x$, délivrant un mot de code $c$ ;
- des moyens de répartition des bits composant le mot de code $c$ dans au moins deux matrices appelées matrices de mappage, inversibles et respectant un critère d'unicité de l'annulation du syndrome associé au mot de code $c$, lesdits moyens de répartition étant appelés moyens de mappage matriciel ;
- des moyens d'émission successive des au moins deux matrices de mappage.

Selon l'invention, le dispositif de réception comprend, pour au moins deux matrices reçues :

- des moyens d'identification d'au moins deux matrices de décodage inversibles à coefficients complexes permettant de respecter un critère de minimisation de la norme du syndrome associé au mot de code $c$ ;
- des moyens de détermination du mot reconstruit à partir des matrices de décodage identifiées.

Selon l'invention, un tel dispositif est notamment adapté à mettre en oeuvre le procédé de réception décrit précédemment.

Ce dispositif de réception pourra bien sûr comporter les différentes caractéristiques relatives au procédé de réception selon l'invention. Ainsi, les caractéristiques et avantages de ce dispositif sont les mêmes que ceux du procédé de réception, et ne sont pas détaillés plus amplement.

L'invention concerne aussi un produit programme d'ordinateur téléchargeable depuis un réseau de communication et/ou enregistré sur un support lisible par ordinateur et/ou exécutable par un processeur, comprenant des instructions de code de programme pour la mise en oeuvre du procédé d'émission ou du procédé de réception tels que décrits ci-dessus.

Les procédés d'émission et de réception selon l'invention peuvent donc être mis en oeuvre de diverses manières, et notamment sous forme câblée ou sous forme logicielle.

## 4. Liste des figures

D'autres caractéristiques et avantages de l'invention apparaîtront plus clairement à la lecture de la description suivante d'un mode de réalisation particulier, donné à titre de simple exemple illustratif et non limitatif, et des dessins annexés, parmi lesquels :

- la figure 1, déjà décrite en relation avec l'art antérieur, présente le schéma général d'un système de transmission MIMO ;
- la figure 2 illustre les principales étapes du procédé d'émission selon un mode de réalisation de l'invention ;

- les figures 3a et 3b illustrent respectivement un exemple de constellation résultante de la modulation matricielle (avec les cosets du groupe de Weyl) et un exemple de système mettant en oeuvre l'invention, selon un premier mode de réalisation particulier du procédé d'émission de l'invention ;
- la figure 4 illustre un exemple de système mettant en oeuvre l'invention, selon un deuxième mode de réalisation particulier (pour le cas d'un code décrit par au moins un treillis comme un code convolutif ou un turbo-code) du procédé d'émission de la figure 2 ;
- les figures 5a et 5b présentent respectivement une représentation de trois sections de treillis à quatre états du code convolutif de Hamming (8,4,4) et une représentation d'une partie du treillis pour le calcul des métriques de branche selon un deuxième mode de réalisation particulier (pour un code décrit par au moins un treillis comme un code convolutif) du procédé d'émission de l'invention ;
- les figures 6a et 6b illustrent respectivement un exemple de système mettant en oeuvre l'invention et un exemple de constellation résultante de la modulation matricielle, selon un troisième mode de réalisation particulier du procédé d'émission de l'invention ;
- la figure 6c illustre un exemple de système mettant en oeuvre l'invention, selon le troisième mode de réalisation particulier du procédé de réception de l'invention ;
- les figures 7a à 7c illustrent respectivement un exemple de constellation résultante de la modulation matricielle selon un quatrième, cinquième et sixième modes de réalisation du procédé d'émission de l'invention ;
- la figure 8 illustre les principales étapes du procédé de réception selon un mode de réalisation de l'invention ;
- les figures 9a et 9b illustrent respectivement un exemple de dispositif d'émission et un exemple de dispositif de réception selon l'invention.

**5. Description d'un mode de réalisation de l'invention**

*5.1 Principe général*

Le principe général de l'invention repose sur une nouvelle modulation codée matricielle, notée MCM, permettant de s'adapter à la modélisation matricielle à coefficients complexes du canal de transmission multi-antennes, ou MIMO, combinée à une fonction de codage correcteur d'erreurs.

L'invention repose plus particulièrement sur l'inversibilité des matrices utilisées pour la modulation, permettant de s'affranchir de la contrainte supposant le canal constant par bloc.

En effet, l'invention suppose seulement que le canal est faiblement variant, de façon continue, ce qui constitue une hypothèse conforme à la réalité des canaux radio-électriques utilisés en pratique, notamment pour les transmissions mobiles.

La nouvelle modulation codée matricielle selon l'invention utilise des sous-ensembles de matrices inversibles à coefficients pris dans une infinité de structures algébriques, corps ou anneaux, comme par exemple les nombres complexes, les nombres quaternioniques d'Hamilton, des nombres hypercomplexes de Cayley,...

L'invention peut fonctionner sans la connaissance du canal (cas non-cohérent dit aussi "en aveugle") ou avec une connaissance totale ou partielle du canal (dit "en semi-aveugle") et est donc plus robuste et performante que les techniques de codage différentielles classiquement utilisées dans les système MIMO, en termes de débit et/ou de qualité de service pour les clients (débit de données plus grand, ou taux d'erreurs plus faible et/ou plus grande portée des émetteurs).

La figure 2 illustre les principales étapes mises en oeuvre coté émission, pour un mot source $x$ à transmettre.

Un tel procédé d'émission met en oeuvre une étape 10 de codage correcteur d'erreurs, délivrant un mot de code c associé au mot source $x$.

Cette étape de codage correcteur d'erreurs permet d'encoder les bits d'information de la séquence binaire source composée d'au moins un mot source $x$, en utilisant au moins un code correcteur d'erreurs. On obtient ainsi au moins un mot de code $c$ en sortie de cette étape 10, qui comprend à la fois des bits d'information et des bits de redondance.

Ce codage correcteur d'erreurs peut être de différents types, selon les modes de réalisation de l'invention, comme par exemple de type code en bloc ou code convolutif, turbo-code, ...

Une étape 11 de mappage, ou mapping, matriciel est ensuite mise en oeuvre, répartissant les bits du mot de code $c$ dans au moins deux matrices de mappage $M_\alpha$ et $M\beta$, inversibles et respectant un critère d'unicité de l'annulation du syndrome associé au mot de code $c$.

Cette étape de mappage permet de répartir les bits du mot de code $c$ de façon à obtenir au moins deux matrices, dites matrices de mappage, particulières, porteuses de l'information utile du mot source $x$. Les particularités de ces matrices sont d'une part leur inversibilité, et d'autre part, le respect d'un critère d'unicité de l'annulation du syndrome associé au mot de code $c$.

Comme décrit dans l'Annexe A, faisant partie intégrante de la description, la propriété d'inversibilité de ces matrices de mappage permet d'obtenir une estimée du canal et donc de s'affranchir de la connaissance du canal.

De plus, comme également décrit dans l'Annexe A, la caractéristique de respect d'un critère d'unicité de l'annulation du syndrome permet de s'assurer qu'un unique mot de code, correspondant à un unique couple de matrices de mappage, annule le syndrome, et permet donc de décoder les matrices reçues de manière performante.

Une fois les matrices de mappage générées, lors de l'étape 11 de mappage, celles-ci sont émises successivement, par les $nt$ antennes d'émission, lors d'une étape 12, après multiplexage le cas échéant.

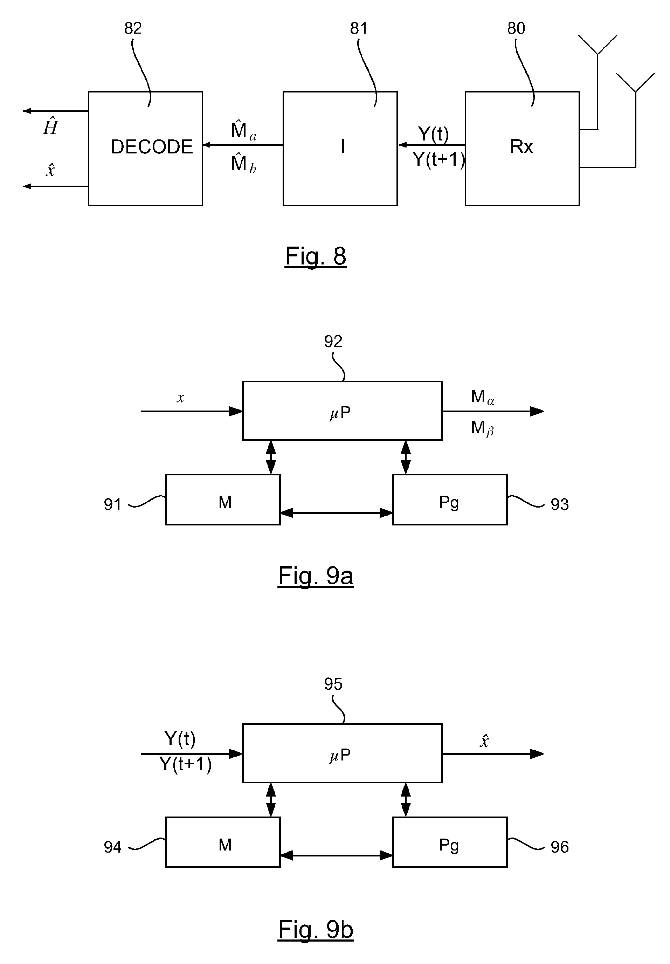

Côté réception, les principales étapes sont illustrées en figure 8.

Après une première étape 80 de réception d'au moins deux matrices $Y(t)$ et $Y(t+1)$, par les $nr$ antennes de réception, le procédé de réception met en oeuvre une étape 81 d'identification d'au moins deux matrices de décodage inversibles à coefficients complexes, notées $(\hat{M}_a, M_b)$. Cette étape d'identification tient compte notamment d'un critère de minimisation de la norme du syndrome associé au mot de code $c$, délivré côté réception par la mise en oeuvre d'un code correcteur d'erreurs, comme déjà décrit ci-dessus. Ce critère doit être respecté par les matrices de décodage identifiées, et s'écrit de la manière suivante :

$$(\hat{M}_a, \hat{M}_b) = Arg \min_{(M_a, M_b)} \left\| Y(t).M_a^{-1} - Y(t+1).M_b^{-1} \right\| \text{ (équation (8) de l'Annexe A)}.$$

Comme déjà indiqué précédemment, les matrices émises sont sélectionnées de telle sorte qu'un unique couple $(\hat{M}_a, \hat{M}_b)$ de matrices de décodage permette de minimiser le syndrome.

Ainsi, un unique mot de code étant associé à cet unique couple de matrices de décodage, le procédé de réception peut reconstruire le mot source, à partir de ces matrices de décodage, lors d'une étape 82 de détermination du mot reconstruit $\hat{x}$, tel que :

$$\hat{x} = Arg \min_{c(x) \in C \rightarrow (M_a, M_b)} \left\| Y_{(t)} M_a^{-1} - Y_{(t+1)} M_b^{-1} \right\|_F$$

$$\text{(équation (9) de l'Annexe A)}.$$

### 5.2 Description d'un premier exemple de réalisation

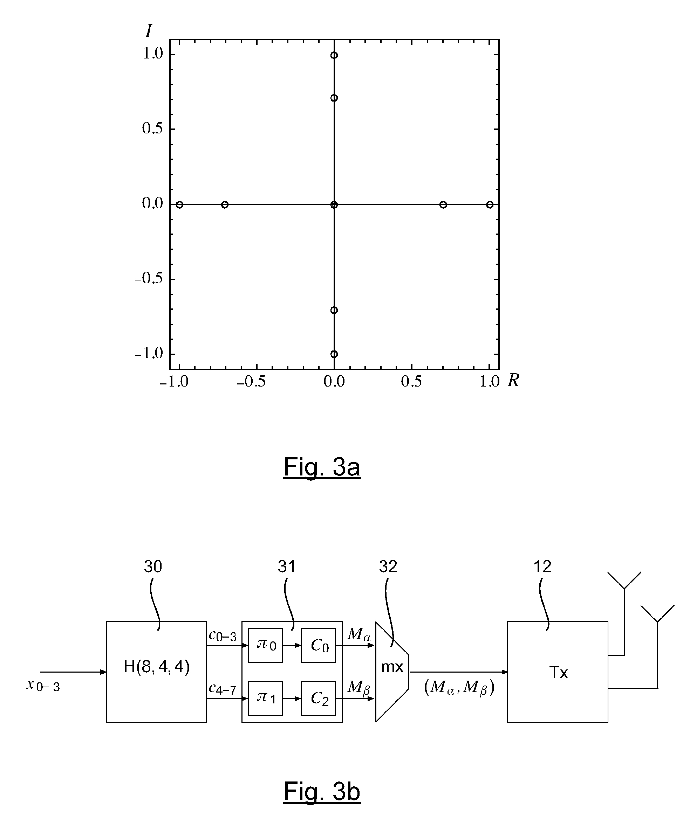

On décrit maintenant, en relation avec les figures 3a et 3b, un premier exemple de réalisation de l'invention, mettant en oeuvre une modulation matricielle 2X2 et un code en bloc de Hamming (8,4,4), pour un système MIMO comprenant deux antennes d'émission et deux antennes de réception.

La matrice génératrice **G** du code en bloc de Hamming (8,4,4) ($n=8$, $k=4$, $d_{min}=4$). bien connu de l'homme du métier, s'écrit : $G = [I_4|P]$, avec $P = \bar{I}_4$, soit :

$$G = \begin{bmatrix} 1 & 0 & 0 & 0 & 1 & 1 & 1 & 1 \\ 0 & 1 & 0 & 0 & 1 & 0 & 1 & 1 \\ 0 & 0 & 1 & 0 & 1 & 1 & 0 & 1 \\ 0 & 0 & 0 & 1 & 1 & 1 & 1 & 0 \end{bmatrix}$$

De plus, dans ce mode de réalisation, les matrices de mappage sont sélectionnées parmi les matrices 2X2 à coefficients complexes inversibles appartenant au groupe de Weyl, noté Gw, tel que décrit notamment dans le document « H. Weyl, "The Classical Groups", Princeton University Press, Princeton, New-Jersey, USA, 1946 ».

Ce groupe de Weyl comporte 192 matrices, pouvant être générées selon une méthode très simple décrite dans le document « F.J. MacWilliams and N.J.A. Sloane, "The theory of error-correcting codes", North-Holland, Amsterdam, 1977, chapitre 19, paragraphe 3 ».

En effet, le groupe Gw se décompose en douze cosets, ou classes latérales, notées $Ck$ avec $k=0, 1,..., 11$.

Le coset $C0$ est le sous-groupe des seize matrices telles que :

$$C_k = a_k.C_0, \ \forall k = 0, 1, \ldots, 11,$$

avec les matrices $a_0, a_1,..., a_5$ telles que :

$$a_0 = \begin{bmatrix} 1 & 0 \\ 0 & 0 \end{bmatrix}, \; a_1 = \begin{bmatrix} 1 & 0 \\ 0 & i \end{bmatrix}, \; a_2 = \frac{1}{\sqrt{2}} \begin{bmatrix} 1 & 1 \\ 1 & -1 \end{bmatrix},$$

$$a_3 = \frac{1}{\sqrt{2}} \begin{bmatrix} 1 & 1 \\ i & -i \end{bmatrix}, \; a_4 = \frac{1}{\sqrt{2}} \begin{bmatrix} 1 & i \\ 1 & -i \end{bmatrix}, \; a_5 = \frac{1}{\sqrt{2}} \begin{bmatrix} 1 & i \\ i & 1 \end{bmatrix},$$

et les matrices $n_6, a_7,..., a_{11}$ telles que :

$$a_{k+6} = \eta a_k \quad , \quad avec \; \eta = (1+i)/\sqrt{2}$$
$$, \; \forall k = 0, 1, \ldots, 5.$$

Selon ce mode de réalisation, les matrices peuvent être par exemple sélectionnées dans les cosets C0 et C2 du groupe de Weyl, afin de respecter le critère d'unicité de l'annulation du syndrome pour des couples de matrices appartenant à ces cosets. Selon un autre exemple, les matrices peuvent être par exemple sélectionnées dans les cosets C1 et C8 du groupe de Weyl, toujours afin de respecter le critère d'unicité de l'annulation du syndrome.

La figure 3a illustre la constellation résultante d'une modulation codée matricielle selon l'invention, avec des matrices de mappage sélectionnées dans les cosets C0 et C2 du groupe de Weyl.

La figure 3b illustre les principales étapes mises en oeuvre à l'émission dans ce mode de réalisation de l'invention.

A partir d'un mot source $x=(x_0, x_1, x_2, x_3)$, portant des informations utiles, une première étape 30 de codage correcteur d'erreurs applique au mot source $x$ le code en bloc de Hamming précédemment décrit, et délivre un mot de code $c = x.G$, avec $c = (c_0, c_1, c_2, c_3, c_4, c_5, c_6, c_7)$.

Comme indiqué ci-dessus, on sélectionne, lors d'une étape 31 de mappage, les deux matrices de mappage à transmettre $M_\alpha$ et $M_\beta$ respectivement dans le coset C0 et C2 du groupe de Weyl, après avoir appliqué deux permutations aux bits du mode de code $c$.

Par exemple, avec les quatre premiers bits $c_{0-3}=(c_0, c_1, c_2, c_3)$ permutés par la permutation identité notée $\pi_0$, on sélectionne la matrice $M_\alpha$ correspondante dans le coset C0, et avec les quatre derniers bits $c_{4-7}=(c_4, c_5, c_6, c_7)$ permutés selon une permutation $\pi_1$, telle que (0,1,2,3) donne (0,3,2,1), on sélectionne la matrice $M_\beta$ correspondante dans le coset C2.

A l'issue de l'étape 31 de mappage, les deux matrices de mappage à transmettre $M_\alpha$ et $M_\beta$ sont multiplexées lors d'une étape 32 de multiplexage $mx$ puis émises successivement lors d'une étape 12.

Côté réception, et comme déjà décrit ci-dessus, l'algorithme de décodage selon l'invention va donc consister à trouver l'unique couple $(M_a, M_b)$ de matrices de décodage, correspondant au mot de code $c$, qui minimise la norme du syndrome (voir l'équation 8 de l'Annexe A).

Comme les matrices $M_\alpha$ et $M_\beta$ émises résultent du codage redondant selon le code en bloc de Hamming (8,4,4) et du mappage du mot de code dans un ensemble de matrices inversibles prises respectivement dans les cosets C0 et C2 du groupe de Weyl, la minimisation du syndrome est effectuée sur l'ensemble des mots de code $c$ possibles et donc sur l'ensemble des mots d'information utile $x$ possibles qui ont pour images ( $M_a, M_b$ )($x$).

Ainsi, le mode de code peut être reconstruit, à partir des matrices reçues, de la manière suivante :

$$\hat{x} = Arg \min_{c(x) \in C \to (M_a, M_b)} \| Y_{(t)} M_a^{-1} - Y_{(t+1)} M_b^{-1} \|_F$$

(équation (9) de

l'Annexe A).

Selon ce mode de réalisation particulier, l'ensemble des mots de code possibles comprend seize mots de code, ce qui donne seize couples de matrices possibles. Une recherche exhaustive parmi ces seize couples de matrices permet d'identifier celui qui minimise la norme du syndrome, puis permet de déterminer le mot de code associé, et donc de reconstruire le mot source.

*5.3 Description d'un deuxième exemple de réalisation*

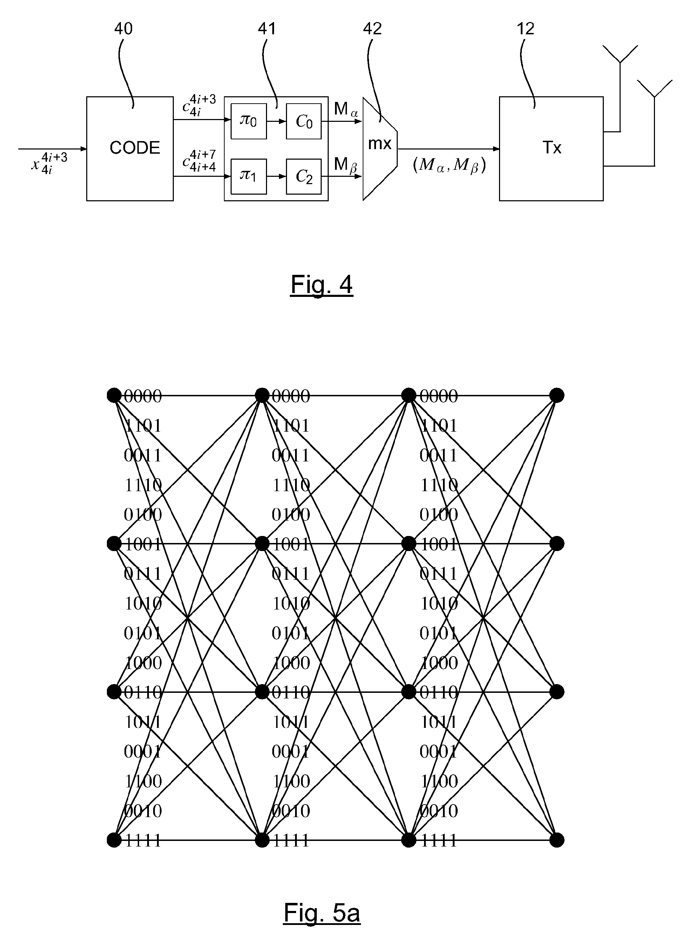

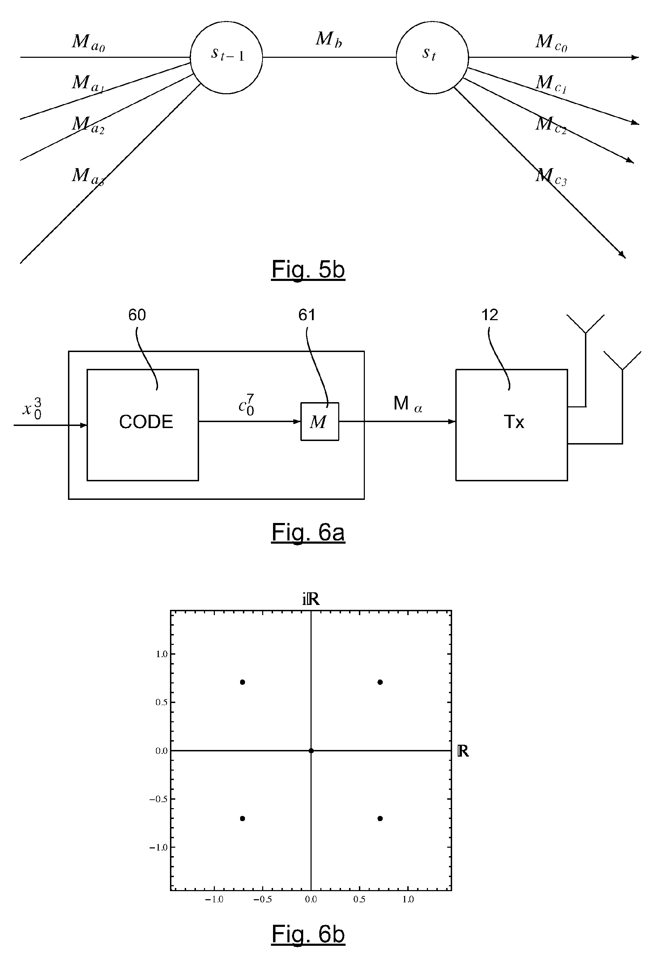

On décrit maintenant, en relation avec les figures 4,5a et 5b, un deuxième exemple de réalisation de l'invention, mettant en oeuvre une modulation matricielle 2X2 et un code correcteur d'erreurs convolutif déduit du code en bloc Hamming(8,4,4) en dépliant et en répétant à l'infini son treillis « tail-biting » à quatre états, pour un système MIMO comprenant deux antennes d'émission et deux antennes de réception.

Ce code convolutif dit de Hamming est construit à partir du treillis dit "tail-biting", ou circulaire, du code en bloc de Hamming décrit précédemment.

Ce petit code convolutif, dont le treillis est très simple, comme illustré en figure 5a pour trois sections à quatre états, permet de généraliser ensuite le principe de ce mode de réalisation à tous les codes pouvant inclure dans leur description un ou plusieurs treillis, comme par exemple les Turbo-codes décrits notamment dans le document « Claude Berrou et al., "Codes et turbocodes ", Ed. Springer, Collection IRIS, 2007 » ou dans le document "A review on issues related to the implementation of turbo codes and space-time trellis codes » Pillai, J.N.; Mneney, S.H.; AFRICON, 2004. 7th AFRICON Conférence in Africa Volume: 1 Publication Year: 2004 , Page(s): 121 - 126 Vol.1 ».

Les paquets ($c_i$, $c_{i+1}$, $c_{i+2}$,...$c_{i+\delta}$) de ($\delta$+1) bits sont notés $c_i^{i+\delta}$

Comme illustré en figure 4, le principe à l'émission est le même que pour le précédent mode de réalisation, mettant en oeuvre un codage en bloc, à la différence près que les bits d'information utiles du mot source *x* sont présentés par paquet de quatre bits $x_{4i}^{4i+3}$ en série. L'étape de codage 40 encode ces bits selon le code convolutif décrit ci-dessus et produit en série des suites de paires de paquets de quatre bits $\left(c_{4i}^{4i+3}, c_{4i+4}^{4i+7}\right)$, où l'entier relatif i est le numéro du paquet de quatre bits.

Ainsi, à partir d'un paquet d'information utile $x_{4i}^{4i+3}$, on obtient, après codage, une paire de paquets $\left(c_{4i}^{4i+3}, c_{4i+4}^{4i+7}\right)$.

Ensuite, on sélectionne, lors d'une étape 41 de mappage, les deux matrices de mappage à transmettre $M_\alpha$ et $M_\beta$ respectivement dans le coset *C0* et le coset *C2* du groupe de Weyl, après avoir appliqué deux permutations aux bits du mot de code *c*.

Par exemple, avec les quatre premiers bits $c_{4i}^{4i+3}$ permutés par la permutation $\pi_0$, on sélectionne la matrice $M_\alpha$ correspondante dans le coset *C0,* et avec les quatre derniers bits $c_{4i+4}^{4i+7}$ permutés selon une permutation $\pi_1$, on sélectionne la matrice $M_\beta$ correspondante dans le coset *C2*.

A l'issue de l'étape 41 de mappage, les deux matrices de mappage à transmettre $M_\alpha$ et $M_\beta$ sont multiplexées lors d'une étape 42 de multiplexage *mx* puis émises successivement lors d'une étape 12.

Côté réception, les signaux reçus sont des matrices 2X2 notées *Yt* et et *Yt+1*.

Les branches du treillis représentant le code correcteur d'erreurs sont étiquetées par des paquets de quatre bits associés de façon bijective aux matrices de mappage déterminées lors de l'émission. Comme illustré en figure 5b, on peut alors considérer que les branches du treillis sont étiquetées par des matrices ($M_a$, $M_b$, $M_c$, ...), qui, bien identifiées pour des sections successives, permettent d'obtenir une unicité du syndrome, comme pour le précédent mode de réalisation avec un codage en bloc.

Dans un premier temps, l'invention prévoit, selon ce mode de réalisation, un calcul spécifique des métriques de branches $\gamma_t$, nécessaires ensuite à l'application, dans un deuxième temps, de l'algorithme de décodage de Viterbi (classiquement utilisé pour un code correcteur d'erreurs convolutif).

Ainsi, par exemple, les valeurs de métriques $\gamma_t$ ($M_b$) correspondant aux métriques de chemin passant par la branche d'étiquette matricielle $M_b$, pour l'instant *t,* sont calculées de la façon suivante, pour trois matrices reçues *Y(t-1) Y(t)* et *Y(t+1)* et trois matrices de décodage $M_a$, $M_b$ et $M_c$ :

$$\gamma_t(M_b) = \min_{(M_a, M_c)} \lambda \left\| Y(t-1).M_a^{-1} - 2Y(t).M_b^{-1} + Y(t+1).M_c^{-1} \right\| + \mu \left\| Y(t) - \hat{H}'(t).M_b \right\|,$$

où $\lambda$ et $\mu$ sont des coefficients de pondération adaptatifs et $\hat{H}'(t)$ est une estimée de la matrice de canal après convergence de l'algorithme de décodage de Viterbi telle que :

$$\hat{H}'(t) = \left( Y(t-1).M_a^{-1} + Y(t).M_b^{-1} + Y(t+1).M_c^{-1} \right)/3.$$

Il est à noter que les coefficients de pondération λ et μ permettent de fusionner les critères connus de la minimisation de la variation du canal et de la distance euclidienne entre le signal reçu et les signaux possiblement émis connaissant la matrice de canal.

Comme illustré en figure 5b, les couples ($M_a$, $M_c$) sont les couples de matrices étiquetant respectivement les branches entrantes de l'état $s_{t-1}$ et les branches sortantes de l'état $s_t$, situées de part et d'autre de la branche étiquetée par $M_b$.

Les estimées $H(t)$ des matrices de canal associées à chacune de ces branches de chaque section du treillis s'écrivent : $\hat{H}_t(M_b) = Y_t . M_b^{-1}$ .

A partir de ces valeurs de métriques calculées selon l'invention, l'algorithme de Viterbi consiste ensuite, de façon connue, à calculer des métriques d'état $\Gamma(s_t)$ telles que :

$$\Gamma(s_t) = \min_{M_b} \left( \Gamma(s_{t-1}) + \gamma_t(M_b) \right)$$

On considère par exemple que les coefficients de pondération λ et μ sont respectivement égaux à 1 et 0, lors de la première itération.

Si on considère deux sections successives, et un filtre d'estimation de la variation du canal comprenant deux coefficients de filtrage respectivement égaux à 1 et -1, les valeurs de métriques $\gamma_t(M_b)$ correspondant aux métriques de chemin passant par la branche d'étiquette matricielle $M_b$ s'écrivent :

$$\gamma_t(M_b) = \min_{(M_a)} \left\| Y_{t-1} M_a^{-1} - Y_t M_b^{-1} \right\|$$

Ces coefficients de filtrage numérique sont classiques pour estimer les dérivées d'ordre 1,2,3... et donc estimer la fenêtre d'invariance d'un signal numérique échantillonné.

Si on considère maintenant trois sections successives, et un filtre d'estimation de la variation du canal comprenant trois coefficients de filtrage respectivement égaux à 1, -2 et 1, les valeurs de métriques $\gamma_t(M_b)$ correspondant aux métriques de chemin passant par la branche d'étiquette matricielle $M_b$ s'écrivent :

$$\gamma_t(M_b) = \min_{(M_a, M_c)} \left\| Y_{t-1} M_a^{-1} - 2Y_t M_b^{-1} + Y_{t+1} M_c^{-1} \right\|$$

Il est à noter que ce dernier cas, avec un filtre d'estimation de la variation du canal à trois coefficients, correspond à l'un des modes de réalisation les plus simples tout en étant très performants.

Si on considère quatre sections successives, et un filtre d'estimation de la variation du canal comprenant quatre coefficients respectivement égaux à 1, -3, +3 et -1, les valeurs de métriques $\gamma_t(M_b)$ correspondant aux métriques de chemin passant par la branche d'étiquette matricielle $M_b$ s'écrivent :

$$\gamma_t(M_b) = \min_{(M_a, M_c, M_d)} \left\| Y(t-1).M_a^{-1} - 3Y(t).M_b^{-1} + 3Y(t+1).M_c^{-1} - Y(t+2).M_d^{-1} \right\|$$

Enfin, si on considère cinq sessions successives, et un filtre d'estimation de la variation du canal comprenant cinq coefficients respectivement égaux à 1, -4, 6, -4 et 1, les valeurs de métriques $\gamma_t(M_b)$ correspondant aux métriques de chemin passant par la branche d'étiquette matricielle $M_b$ s'écrivent :

$$\gamma_t(M_c) = \min_{(M_a, M_b, M_d, M_e)} \left\| Y_{t-2} M_a^{-1} - 4Y_{t-1} M_b^{-1} + 6Y_t M_c^{-1} - 4Y_{t+1} M_c^{-1} + Y_{t+2} M_d^{-1} \right\|$$

*5.4 Description d'un troisième exemple de réalisation*

On décrit maintenant, en relation avec les figures 6a à 6c, un troisième exemple de réalisation de l'invention, mettant en oeuvre une modulation matricielle 2X2 et un code correcteur d'erreurs convolutif de Golay, pour un système MIMO comprenant deux antennes d'émission et deux antennes de réception.

Selon ce mode de réalisation, les matrices de mappage ne sont plus sélectionnées dans le groupe de Weyl, mais construites, de manière à respecter les propriétés requises par l'invention, à savoir l'inversibilité et le respect du critère d'unicité de l'annulation du syndrome.

Ainsi, comme illustré en figure 6a, à partir d'une "fenêtre flottante"(« sliding windows » en anglais) de quatre bits $x_0^3 = (x_0, x_1, x_2, x_3)$ d'information à transmettre, l'étape 60 de codage convolutif produit huit bits $c_0^7 = (c_0, c_1, c_2, \ldots c_7)$.

Le code utilisé est par exemple le code de Golay convolutif décrit dans l'article « E. Cadic, J.C. Carlach, G. Olocco, A. Otmani and J.P. Tillich, "Low Complexity Tail-Biting Trellises of Self-Dual Codes of Length 24, 32 and 40 over GF(4) and Z4 of Large Minimun Distance", In Proceedings of the 14th International Symposium on Applied Algebra, Algebraic Algorithms and Error-Correcting Codes (AAECC'14), Melbourne (Australia), S. Boztas and I. Shparlinski (Eds.), Ed. Sprinter Verlag, , pp.57-66, November 2001 ».

Lors d'une étape 61 de mappage, les six bits $c_2^7 = (c_2, \ldots c_7)$ sont regroupés en trois paires $(c_2, c_3)$, $(c_4, c_5)$ et $(c_6, c_7)$, mappées chacune selon le mappage de Gray, pour obtenir un triplet de symboles complexes $(s_0, s_1, s_2)$ tel que :

$$(0,0) \iff +1 + \mathcal{I}$$

$$(0,1) \iff -1 + \mathcal{I}$$

$$(1,1) \iff -1 - \mathcal{I}$$

$$(1,0) \iff +1 - \mathcal{I},$$

avec $\mathcal{I}$ le nombre complexe imaginaire pur tel que $\mathcal{I}^2 = -1$.

Les deux premiers bits $(c_0, c_1)$ sont mappés en insérant le nombre complexe 0 en place $(2c_0+1)$ dans le triplet de symboles complexes obtenu précédemment, pour obtenir un quadruplet de symboles complexes, transformé ensuite en une matrice 2X2 $M_\alpha$ telle que :

$$(0,0) \iff (0, s_0, s_1, s_2) \iff \begin{pmatrix} 0 & s_0 \\ s_1 & s_2 \end{pmatrix}$$

$$(0,1) \iff (s_0, 0, s_1, s_2) \iff \begin{pmatrix} s_0 & 0 \\ s_1 & s_2 \end{pmatrix}$$

$$(1,0) \iff (s_0, s_1, 0, s_2) \iff \begin{pmatrix} s_0 & s_1 \\ 0 & s_2 \end{pmatrix}$$

$$(1,1) \iff (s_0, s_1, s_2, 0) \iff \begin{pmatrix} s_0 & s_1 \\ s_2 & 0 \end{pmatrix}$$

On note que ces matrices respectent les critères nécessaires à la mise en oeuvre de l'invention. Elles sont en effet inversibles, correspondent chacune à une et une seule combinaison de huit bits et permettent d'obtenir une modulation dont la constellation est illustrée en figure 6b.

Il est à noter que l'on peut multiplier ces matrices par une constante, sans compromettre ces critères. La constante peut par exemple être $1/\sqrt{2}$, afin de normaliser ces matrices.

Ces étapes sont mises en oeuvre pour les bits d'information suivants à transmettre, de manière à obtenir au moins une autre matrice de mappage $M_\beta$.

Les paquets d'information utiles arrivent par fenêtre flottante de quatre bits, puis ils sont encodés pour produire huit bits codés. Un paquet codé de huit bits est donc ensuite mappé comme décrit précédemment pour produire une matrice inversible 2x2 à coefficients complexes. Comme le code de Golay convolutif a un treillis minimal à seize états, les deux paquets de quatre bits précédant et suivant le paquet de la section sont encodés en deux paquets de huit bits précédant et suivant le paquet de huit bits courant. Cette relation de codage permet d'obtenir après mappage trois matrices inversibles successives émises d'indices (t-1), t et (t+1) pour lesquelles il y a aussi unicité du syndrome sur le treillis du code convolutif.

Comme pour les modes de réalisation précédemment décrits, ces matrices de mappage sont transmises successivement lors d'une étape 12.

Côté réception, le décodage s'effectue de la même façon que pour le mode de réalisation utilisant un code de Hamming convolutif.

Comme déjà décrit dans ce mode de réalisation, l'invention prévoit un calcul nouveau des métriques de branche, permettant notamment d'utiliser le code pour "mapper" directement une suite de "fenêtres" d'information utile en une suite de matrices inversibles.

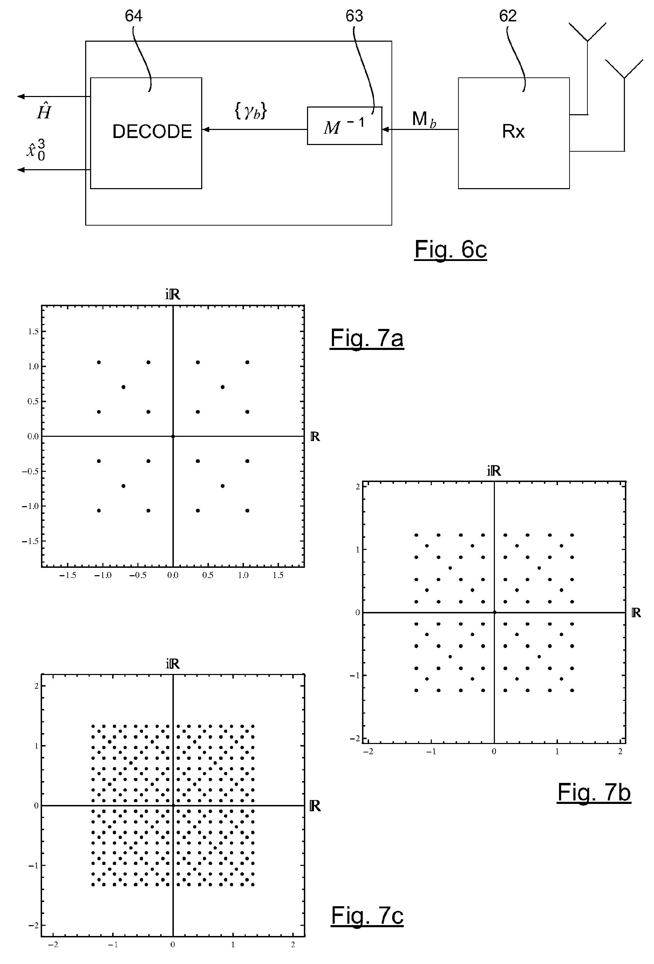

La figure 6c illustre les principales étapes du procédé de réception selon ce mode de réalisation de l'invention.

La première étape 62 de réception consiste à recevoir au moins deux matrices $Y(t)$ et $Y(t+1)$ et à identifier au moins deux matrices de décodage, inversibles et respectant le critère de minimisation de la norme du syndrome associé au mot de code $c$ généré à l'émission.

L'étape de calcul de métrique 63 met en oeuvre le calcul spécifique des métriques de branche, à partir d'au moins une matrice de décodage $M_b$, de façon à délivrer au moins une métrique $\gamma_t(M_b)$ utilisée dans l'algorithme de décodage de Viterbi, lors de l'étape 64 de décodage par détection sur le treillis du code.

A l'issue de cette étape 64, on obtient une estimée $\hat{x}_0^3$ du mot source $x$ émis, ainsi qu'une estimée $\hat{H}$ du canal.

*5.5 Description d'un quatrième exemple de réalisation*

Comme déjà indiqué précédemment, l'invention permet, selon un quatrième mode de réalisation, de transmettre seize bits codés $c_{0-15}$.

Pour ce faire, l'invention utilise une modulation proche de la modulation MAQ16, où le premier niveau est mappé vers $(\pm 1 \pm \mathcal{I})$, comme pour le mode de réalisation précédent, et le deuxième niveau vers $(\pm 1 \pm \mathcal{I})/2$.

Selon ce mode de réalisation de l'invention, les huit premiers bits sont mappés de façon à obtenir une première matrice inversible A = $M(c_{0-7})$ et les huit derniers bits $c_{8-15}$ sont mappés de façon à obtenir une deuxième matrice inversible B = $M(c_{8-15})$.

La matrice globale de mappage obtenue correspond à la somme $(A+ B/2)$ qui est une matrice inversible à coefficients complexes dont la constellation est représentée en figure 7a.

Les autres étapes à l'émission, puis à la réception, sont identiques au troisième mode de réalisation décrit ci-dessus.

*5.6 Description d'un cinquième exemple de réalisation*

L'invention permet également, selon un cinquième mode de réalisation, de transmettre vingt-quatre bits codés $c_{0-23}$.

Pour ce faire, l'invention utilise un mappage différent pour chacun des trois groupes de huit bits $c_{0-7}$, $c_{8-15}$ et $c_{16-23}$, pour obtenir trois matrices inversibles *A, B* et *C*.

La matrice globale de mappage obtenue correspond à la somme $(A+ B/2 +C/4)$ qui est une matrice inversible à coefficients complexes dont la constellation est représentée en figure 7b.

Les autres étapes à l'émission, puis à la réception, sont identiques au troisième mode de réalisation décrit ci-dessus.

*5.6 Description d'un sixième exemple de réalisation*

Selon un sixième mode de réalisation, l'invention permet de transmettre trente deux bits codés $c_{0-31}$.

Pour ce faire, l'invention utilise un mappage différent pour chacun des quatre groupes de huit bits $c_{0-7}$, $c_{8-15}$,

$c_{16\text{-}23}$ et $c_{24\text{-}31}$, pour obtenir quatre matrices inversibles *A, B, C et D*.

La matrice globale de mappage obtenue correspond à la somme (A+ *B*/2 +*C*/4 +*D*/8) qui est une matrice inversible à coefficients complexes dont la constellation est représentée en figure 7c.

Les autres étapes à l'émission, puis à la réception, sont identiques au troisième mode de réalisation décrit ci-dessus.

*5.7 Autres exemples de réalisation*

Les modes de réalisation ci-dessus peuvent être généralisés en considérant *n* matrices de mappage $A_n$, avec *n* un entier non nul, et une matrice de mappage globale à émettre correspondant à la somme $A + \sum_{i=1}^{n} \frac{A_i}{2^i}$.

L'invention peut également être mise en oeuvre à chaque fois qu'un code convolutif est utilisé, par exemple pour des Turbo-codes qui utilisent au moins deux codes convolutifs séparés par un entrelaceur-permutation.

L'invention peut également s'appliquer pour des codes LDPC (Low-Density Parity Check codes), en mappant des blocs de bits vers des matrices inversibles.

Pour le décodage itératif des codes LDPC et Turbo-codes, la propagation d'information extrinsèque peut se faire à la fois pour les symboles d'information utile et sur les matrices estimées du canal faiblement variant, selon l'invention.

L'invention a essentiellement été décrite dans le contexte d'un canal MIMO qui, dans un environnement de transmission par câble, est dit de type multi-émetteurs et multi-récepteurs. L'invention peut également être mise en oeuvre dans le contexte d'un canal SISO. Dans ce cas, les symboles des matrices sont émis de manière successive.

*5.8 Structure simplifiée des dispositifs d'émission et de réception correspondants*

On présente finalement, en relation avec les figures 9a et 9b, la structure simplifiée d'un dispositif d'émission et d'un dispositif de réception mettant respectivement en oeuvre une technique d'émission et une technique de réception selon l'un des exemples de réalisation décrits ci-dessus.

Un tel dispositif d'émission comprend une mémoire 91, une unité de traitement 92, équipée par exemple d'un microprocesseur $\mu$P, et pilotée par le programme d'ordinateur 93, mettant en oeuvre le procédé d'émission selon l'invention.

A l'initialisation, les instructions de code du programme d'ordinateur 93 sont par exemple chargées dans une mémoire RAM avant d'être exécutées par le processeur de l'unité de traitement 92. L'unité de traitement 92 reçoit en entrée une séquence binaire source x. Le microprocesseur de l'unité de traitement 92 met en oeuvre les étapes du procédé d'émission décrit précédemment, selon les instructions du programme d'ordinateur 93, pour coder, et mapper la séquence binaire source, et émettre des matrices de mappage. Pour cela, le dispositif d'émission comprend, outre la mémoire tampon 91, des moyens de codage correcteur d'erreurs du mot source x, délivrant un mot de code c, des moyens de mappage matriciel du mot de code *c*, répartissant les bits composant le mot de code *c* dans au moins deux matrices de mappage, inversibles et respectant un critère d'unicité de l'annulation du syndrome associé au mot de code *c* et des moyens d'émission successive des deux matrices de mappage. Ces moyens sont pilotés par le microprocesseur de l'unité de traitement 92.

L'unité de traitement 92 transmet donc à destination d'un récepteur, via un canal de transmission, un signal modulé sous la forme de matrices.

Le dispositif de réception de la figure 9b comprend quant à lui une mémoire 94, une unité de traitement 95, équipée par exemple d'un microprocesseur $\mu$P, et pilotée par le programme d'ordinateur 96, mettant en oeuvre le procédé de réception selon l'invention.

A l'initialisation, les instructions de code du programme d'ordinateur 96 sont par exemple chargées dans une mémoire RAM avant d'être exécutées par le processeur de l'unité de traitement 95. L'unité de traitement 95 reçoit en entrée des matrices *Y(t)* et *Y(t+1)*. Le microprocesseur de l'unité de traitement 95 met en oeuvre les étapes du procédé de réception décrit précédemment, selon les instructions du programme d'ordinateur 96, pour identifier des matrices de décodage et reconstruire un mot $\hat{x}$. Pour cela, le dispositif de réception comprend, outre la mémoire tampon 94, des moyens d'identification d'au moins deux matrices de décodage inversibles à coefficients complexes permettant de respecter un critère de minimisation de la norme du syndrome associé au mot de code *c* et des moyens de détermination du mot reconstruit à partir des matrices de décodage identifiées. Ces moyens sont pilotés par le microprocesseur de l'unité de traitement 95.

ANNEXE A

## Calculs théoriques du codage MCM avec le code en bloc de Hamming(8, 4, 4)

Pour chaque temps-symbole t, le couple des signaux $Y_t = (y_{t,1}, y_{t,2})$ reçus par les antennes 1 et 2 peut s'écrire en fonction du couple des signaux émis $X_t = (x_{t,1}, x_{t,2})$ et de la matrice de transfert du canal $H_t$ tel que :

$$y_{t,1} = h_{t,1,1} * x_{t,1} + h_{t,2,1} * x_{t,2}$$

$$y_{t,2} = h_{t,1,2} * x_{t,1} + h_{t,2,2} * x_{t,2} \qquad (1)$$

Soit, à chaque instant-symbole discret $t : Y_t = H_t . X_t$

Pour un couple de temps-symboles successifs (*2t, 2t+1*), pair et impair, noté en abrégé (*t*), on peut écrire les deux vecteurs de deux signaux reçus par les antennes pendant ces deux temps-symboles tels que :

$$Y_{2t} = H_{2t} . X_{2t} + N_{2t}$$

$$Y_{2t+1} = H_{2t+1} . X_{2t+1} + N_{2t+1}$$
$$= H_{2t} . X_{2t+1} + \Delta H_{2t}^{2t+1} . X_{2t+1} + N_{2t+1} \qquad (2)$$

où $\Delta H_{2t}^{2t+1} = H_{2t+1} - H_{2t}$ est la matrice de variation du canal entre les instants *2t* et *2t+1*. On fait l'hypothèse réaliste que la réponse du canal varie peu entre deux instants pair et impair successifs (*2t, 2t+1*), soit : $\Delta H_{2t}^{2t+1} \approx 0$.

On peut donc écrire sous la forme matricielle :

$$\begin{bmatrix} Y_{2t} \\ Y_{2t+1} \end{bmatrix} = H_{2t} . \begin{bmatrix} X_{2t} \\ X_{2t+1} \end{bmatrix} + \Delta H_{2t}^{2t+1} . \begin{bmatrix} 0 \\ X_{2t+1} \end{bmatrix} + \begin{bmatrix} N_{2t} \\ N_{2t+1} \end{bmatrix},$$

en définissant les matrices 2X2 des signaux respectivement émis, reçus et du bruit $X(t), Y(t)$ et $N(t)$ pendant les deux temps-symboles *(2t, 2t+1)* telles que :

$$X(t) = \begin{bmatrix} X_{2t} \\ X_{2t+1} \end{bmatrix}, Y(t) = \begin{bmatrix} Y_{2t} \\ Y_{2t+1} \end{bmatrix}, N(t) = \begin{bmatrix} N_{2t} \\ N_{2t+1} \end{bmatrix},$$

où $N(t)$ est la matrice des bruits pendant deux temps-symboles sur les deux antennes, supposés statistiquement indépendants, de distribution de probabilité gaussienne, blancs, de moyenne nulle (AWGN), et en posant de plus :

$$H(t) = H_{2t}, \ \Delta H'_{(t)} = \begin{bmatrix} 0 & 1 \\ 0 & 1 \end{bmatrix} . \Delta H_{2t}^{2t+1}$$

On peut alors écrire la matrice carrée $Y(t)$ des signaux reçus pendant deux temps-symboles *(2t, 2t+1)* sous la forme :

$$Y(t) = H(t) . X(t) + \Delta H'_{(t)} . X(t) + N(t) \qquad (3)$$

Si le canal varie peu entre deux temps-symboles, on peut considérer que l'on émet des symboles $X(t)$ qui sont des matrices 2X2 à coefficients complexes.

On suppose de plus que les symboles $X(t)$ et $X(t+1)$ successifs émis sont mappés dans deux matrices inversibles sélectionnées dans un alphabet A de matrices inversibles tels que $X(t) = M_\alpha$ et $X(t+1) = M_\beta$

On a donc à la réception :

$$
\begin{aligned}
Y_{(t)} &= \mathbf{H}_{(t)} \cdot \mathbf{M}_\alpha &&+ \Delta \mathbf{H}'_{(t)} \cdot \mathbf{M}_\alpha &&+ \mathbf{N}_{(t)} \\
Y_{(t+1)} &= \mathbf{H}_{(t+1)} \cdot \mathbf{M}_\beta &&+ \Delta \mathbf{H}'_{(t+1)} \cdot \mathbf{M}_\beta &&+ \mathbf{N}_{(t+1)}
\end{aligned}
\tag{4}
$$

On considère maintenant que le canal est peu variant dans le temps, c'est-à-dire pendant les quatre temps-symboles nécessaires à l'envoi d'un mot de code ou d'une fenêtre de bits codés de longueur quelconque, c'est-à-dire que l'on peut écrire *H=H(t)=H(t+1)* et, à la réception :

$$
Y(t)=H(t).M_\alpha + N(t)
$$

$$
Y(t+1)=H(t+1).M_\beta + N(t+1)
\tag{5}
$$

Si on multiplie la matrice *Y(t)* par une matrice inverse notée $M_a^{-1}$ et la matrice *Y(t+1)* par une matrice inverse notée $-M_b^{-1}$, et qu'on additionne ces deux produits, on obtient le syndrome analogique, noté *Synd*, associé au mot de code c transmis, par analogie au syndrome binaire connu :

$$
S_{ynd} = Y_{(t)} M_a^{-1} - Y_{(t+1)} M_b^{-1}
\tag{6}
$$

Si on remplace, dans l'équation (6), les vecteurs reçus par leurs expressions respectives de l'équation (5), on obtient l'expression suivante pour le syndrome :

$$
Synd = H_{(t)}(M_\alpha M_a^{-1} - M_\beta M_b^{-1}) + \Delta
\tag{7}
$$

avec le terme correctif $\Delta = N_{(t)} M_a^{-1} - N_{(t+1)} M_b^{-1}$.

Pour s'affranchir en grande partie de la connaissance a priori de la matrice de canal *H(t)*, il faut donc que la matrice $(M_\alpha M_a^{-1} - M_\beta M_b^{-1})$ soit le plus proche possible de la matrice nulle $O_{2X2}$. La matrice $(M_\alpha M_a^{-1} - M_\beta M_b^{-1})$ joue alors le rôle équivalent d'une matrice de contrôle du code correcteur d'erreurs utilisé.

L'algorithme de décodage va donc consister à trouver, parmi l'ensemble des couples $(M_a, M_b)$ de matrices correspondant aux mots de code *c* possibles émis, l'unique couple $(M_a, M_b)$ qui minimise la norme du syndrome, tel que :

$$
(\hat{M}_a, \hat{M}_b) = Arg \min_{(M_a, M_b)} \left\| Y(t).M_a^{-1} - Y(t+1).M_b^{-1} \right\|, \tag{8}
$$

où $\|\cdot\|$ représente la norme d'une matrice, par exemple la norme de Frobenius, notée $\|\cdot\|_F$, correspondant à la somme des modules de chacun des coefficients de la matrice.

Comme les matrices $M_\alpha$ et $M_\beta$ émises résultent du codage redondant selon le code correcteur d'erreurs choisi et du mappage du mot de code dans un ensemble de matrices inversibles, la minimisation du syndrome est effectuée sur l'ensemble des mots de code c possibles et donc sur l'ensemble des mots d'information utile *x* possibles qui ont pour images $(M_a, M_b)(x)$.

Ainsi, le mode de code reconstruit, à partir des matrices reçues, s'écrit de la manière suivante :

$$
\hat{x} = Arg \min_{c(x) \in C \to (M_a, M_b)} \| Y_{(t)} M_a^{-1} - Y_{(t+1)} M_b^{-1} \|_F
$$

$$
\tag{9}
$$

De plus, on obtient également, après avoir résolu la minimisation du syndrome, deux estimées bruitées de la matrice de canal *H(t)* telles que :

$$\hat{\mathbf{H}}_{(t)}^1 = Y_{(t)}M_a^{-1} = \mathbf{H}_{(t)} + N_{(t)}M_a^{-1}$$
$$\hat{\mathbf{H}}_{(t)}^2 = Y_{(t+1)}M_b^{-1} = \mathbf{H}_{(t)} + N_{(t+1)}M_b^{-1} \tag{10}.$$

## Revendications

1. **Procédé d'émission** d'une séquence binaire source comprenant au moins un mot source x, dans un canal de transmission,
   **caractérisé en ce qu'**il comprend les étapes suivantes, pour au moins un mot source :

   - codage (10) correcteur d'erreurs dudit mot source *x*, délivrant un mot de code *c* ;
   - répartition (11) des bits composant ledit mot de code *c* dans au moins deux matrices appelées matrices de mappage, inversibles et respectant un critère d'unicité de l'annulation du syndrome associé audit mot de code *c* de sorte qu'un unique mot de code correspondant à un unique couple de matrices de mappage annule le syndrome associé audit mot de code, lesdites matrices de mappage étant porteuses de l'information utile du mot source x, ladite étape de répartition étant appelée étape de mappage matriciel et mettant en oeuvre une correspondance bijective entre les bits dudit mot de code *c* et lesdites au moins deux matrices de mappage ;
   - émission (12) successive desdites au moins deux matrices de mappage.

2. Procédé d'émission selon la revendication 1, **caractérisé en ce que** ledit critère d'unicité de l'annulation du syndrome s'écrit de la façon suivante, pour une étape de mappage matriciel délivrant deux matrices à émettre $M_\alpha$ et $M_\beta$ associées audit mot de code *c* :

$$M_\alpha . M_a^{-1} - M_\beta . M_b^{-1} = 0 ,$$

   avec ( $M_a$, $M_b$) un unique couple de matrices correspondant audit mot de code *c* dans un cas parfait de canal de transmission constant.

3. Procédé d'émission selon la revendication 1, **caractérisé en ce que** ladite étape de mappage comprend une sous-étape de permutation desdits bits dudit mot de code *c*, préalable à ladite répartition desdits bits composant ledit mot de code *c*.

4. Procédé d'émission selon la revendication 1, **caractérisé en ce que** ladite étape de mappage répartit au moins quatre bits ($c_0, c_1, c_2, c_3$) composant ledit mot de code *c* dans une matrice de mappage et **en ce que** ladite matrice de mappage est sélectionnée dans un ensemble connu de matrices inversibles à coefficients complexes, noté groupe de Weyl.

5. Procédé d'émission selon la revendication 1, **caractérisé en ce que** ladite étape de mappage répartit au moins huit bits ($c_0, c_1, c_2,...c_7$) composant ledit mot de code *c* dans une matrice de mappage *A* et comprend les sous-étapes suivantes :

   - mappage selon le mappage de Gray des paires ($c_2,c_3$), ($c_4,c_5$) et ($c_6,c_7$) délivrant un triplet de symboles complexes ($s_0, s_1, s_2$) ;
   - mappage de la paire ($c_0, c_1$) en insérant le nombre complexe 0 en place ($2c_0+1$) dans ledit triplet de symboles complexes délivrant un quadruplet de symboles complexes ;
   - répartition desdits symboles complexes dudit quadruplet dans une matrice de mappage inversible *A*.

6. Procédé d'émission selon la revendication 5, **caractérisé en ce que** ladite étape de mappage comprend en outre *n* étapes de répartition d'au moins huit bits composant ledit mot de code *c*, respectivement dans au moins *n* matrices de mappage $A_n$, avec *n* un entier non nul, et **en ce que** ledit procédé comprend une étape de calcul d'une matrice de mappage globale à émettre correspondant à la somme $\mathcal{I}$

**7.** Dispositif d'émission d'une séquence binaire source comprenant au moins un mot source *x*, dans un canal de transmission,
**caractérisé en ce qu'**il met en oeuvre, pour au moins un mot source :

- des moyens de codage correcteur d'erreurs dudit mot source *x*, délivrant un mot de code *c* ;
- des moyens de répartition des bits composant ledit mot de code c dans au moins deux matrices appelées matrices de mappage, inversibles et respectant un critère d'unicité de l'annulation du syndrome associé audit mot de code *c*, de sorte qu'un unique mot de code correspondant à un unique couple de matrices de mappage annule le syndrome associé audit mot de code, lesdites matrices de mappage étant porteuses de l'information utile du mot source x, lesdits moyens de répartition étant appelés moyens de mappage matriciel et mettant en oeuvre une correspondance bijective entre les bits dudit mot de code *c* et lesdites au moins deux matrices de mappage ;
- des moyens d'émission successive desdites au moins deux matrices de mappage.

**8. Procédé de réception** d'une séquence binaire émise, après passage de ladite séquence binaire émise dans un canal de transmission, délivrant une séquence binaire reconstruite comprenant au moins un mot reconstruit, ladite séquence binaire émise étant obtenue à partir d'une séquence binaire comprenant au moins un mot source *x,* ayant subi avant émission les étapes suivantes, pour au moins un mot source *x* :

- codage correcteur d'erreurs dudit mot source *x*, délivrant un mot de code *c* ;
- répartition des bits composant ledit mot de code *c* dans au moins deux matrices appelées matrices de mappage, inversibles et respectant un critère d'unicité de l'annulation du syndrome associé audit mot de code *c*, lesdites matrices de mappage étant porteuses de l'information utile du mot source *x*, ladite étape de répartition étant appelée étape de mappage matriciel et mettant en oeuvre une correspondance bijective entre les bits dudit mot de code *c* et lesdites au moins deux matrices de mappage;
- émission successive desdites au moins deux matrices de mappage,
**caractérisé en ce que** ledit procédé de réception comprend les étapes suivantes, pour au moins deux matrices reçues :

  - identification (81) d'au moins deux matrices de décodage inversibles à coefficients complexes permettant de respecter un critère de minimisation de la norme du syndrome associé audit mot de code *c*, les matrices de mappage émises étant sélectionnées de telle sorte qu'un unique couple de matrices de décodage permette de minimiser la norme du syndrome ;
  - détermination (82) dudit mot reconstruit à partir desdites matrices de décodage identifiées.

**9.** Procédé de réception selon la revendication 8, **caractérisé en ce que** ledit critère de minimisation de la norme du syndrome associé audit mot de code *c* s'écrit de la façon suivante, pour deux matrices reçues *Y(t)* et *Y(t+1)* et deux matrices de décodage $M_a$ et $M_b$ :

$$(\hat{M}_a, \hat{M}_b) = Arg \min_{(M_a, M_b)} \left\| Y(t).M_a^{-1} - Y(t+1).M_b^{-1} \right\| \ ,$$

où $\|\cdot\|$ représente la norme d'une matrice.

**10.** Procédé de réception selon la revendication 8, **caractérisé en ce qu'**il comprend, préalablement à ladite étape de détermination dudit mot reconstruit, les étapes suivantes, pour un codage correcteur d'erreurs mettant en oeuvre un code convolutif représenté en treillis :

- détermination des métriques des branches des sections dudit treillis dudit code convolutif, chaque branche étant étiquetée par une desdites matrices de décodage ;
- mise en oeuvre de l'algorithme de décodage de Viterbi, à partir desdites métriques de branche, délivrant des métriques d'état.

**11.** Procédé de réception selon la revendication 10, **caractérisé en ce qu'**une métrique $\gamma_t(M_b)$ d'une desdites branches étiquetée par une matrice de décodage $M_b$ est déterminée par l'équation suivante, pour trois matrices reçues *Y(t-1)*, *Y(t)* et *Y(t+1)* et trois matrices de décodage $M_a$, $M_b$ et $M_c$ :

$$\gamma_t(M_b) = \min_{(M_a, M_c)} \lambda \left\| Y(t-1).M_a^{-1} - 2Y(t).M_b^{-1} + Y(t+1).M_c^{-1} \right\| + \mu \left\| Y(t) - \hat{H}'(t).M_b \right\|,$$

où $\lambda$ et $\mu$ sont des coefficients de pondération adaptatifs et $\hat{H}'(t)$ est une estimée de la matrice de canal après convergence de l'algorithme de décodage de Viterbi telle que :

$$\hat{H}'(t) = \left( Y(t-1).M_a^{-1} + Y(t).M_b^{-1} + Y(t+1).M_c^{-1} \right) \big/ 3 .$$

12. Dispositif de réception d'une séquence binaire émise, après passage de ladite séquence binaire émise dans un canal de transmission, délivrant une séquence binaire reconstruite comprenant au moins un mot reconstruit, ladite séquence binaire émise étant obtenue à partir d'une séquence binaire comprenant au moins un mot source x, pour lequel ont été mis en oeuvre, avant émission :

   - des moyens de codage correcteur d'erreurs dudit mot source x, délivrant un mot de code c ;
   - des moyens de répartition des bits composant ledit mot de code c dans au moins deux matrices appelées matrices de mappage, inversibles et respectant un critère d'unicité de l'annulation du syndrome associé audit mot de code c, lesdites matrices de mappage étant porteuses de l'information utile du mot source x, lesdits moyens de répartition étant appelés moyens de mappage matriciel et mettant en oeuvre une correspondance bijective entre les bits dudit mot de code c et lesdites au moins deux matrices de mappage ;
   - des moyens d'émission successive desdites au moins deux matrices de mappage, **caractérisé en ce que** ledit dispositif de réception comprend, pour au moins deux matrices reçues :
   - des moyens d'identification d'au moins deux matrices de décodage inversibles à coefficients complexes permettant de respecter un critère de minimisation de la norme du syndrome associé audit mot de code c, les matrices de mappage émises étant sélectionnées de telle sorte qu'un unique couple de matrices de décodage permette de minimiser la norme du syndrome ;
   - des moyens de détermination dudit mot reconstruit à partir desdites matrices de décodage identifiées.

13. Programme d'ordinateur comportant des instructions pour la mise en oeuvre du procédé de selon la revendication 1 ou la revendication 8 lorsque ledit programme est exécuté par un processeur.

**Patentansprüche**

1. Verfahren zum Senden einer mindestens ein Ausgangswort x enthaltenden Ausgangsbitfolge in einem Übertragungskanal,
   **dadurch gekennzeichnet, dass** es die folgenden Schritte für mindestens ein Ausgangswort enthält:

   - Fehlerkorrekturcodierung (10) des Ausgangsworts x, die ein Codewort c liefert;
   - Verteilung (11) der das Codewort c bildenden Bits in mindestens zwei Abbildungsmatrizen genannten Matrizen, die umkehrbar sind und ein Einzigkeitskriterium der Unterdrückung des dem Codewort c zugeordneten Syndroms beachten, so dass ein einziges Codewort entsprechend einem einzigen Paar von Abbildungsmatrizen das dem Codewort zugeordnete Syndrom unterdrückt, wobei die Abbildungsmatrizen die nützliche Information des Ausgangsworts x tragen, wobei der Verteilungsschritt Matrixabbildungsschritt genannt wird und eine eineindeutige Entsprechung zwischen den Bits des Codeworts c und den mindestens zwei Abbildungsmatrizen anwendet;
   - aufeinanderfolgendes Senden (12) der mindestens zwei Abbildungsmatrizen.

2. Sendeverfahren nach Anspruch 1, **dadurch gekennzeichnet, dass** das Einzigkeitskriterium der Unterdrückung des Syndroms für einen Matrixabbildungsschritt, der zwei zu sendende Matrizen $M_\alpha$ und $M_\beta$ liefert, die dem Codewort c zugeordnet sind, folgendermaßen geschrieben wird:

$$M_\alpha.M_\alpha^{-1} - M_\beta.M_b^{-1} = 0,$$

mit ($M_a$, $M_b$) einem einzigen Matrizenpaar entsprechend dem Codewort c in einem perfekten Fall eines konstanten Übertragungskanals.

3. Sendeverfahren nach Anspruch 1, **dadurch gekennzeichnet, dass** der Abbildungsschritt einen Teilschritt der Permutation der Bits des Codeworts c vor der Verteilung der das Codewort c bildenden Bits enthält.

4. Sendeverfahren nach Anspruch 1, **dadurch gekennzeichnet, dass** der Abbildungsschritt mindestens vier das Codewort c bildende Bits ($c_0$, $c_1$, $c_2$, $c_3$) in einer Abbildungsmatrix verteilt, und dass die Abbildungsmatrix aus einer bekannten Einheit von umkehrbaren Matrizen mit komplexen Koeffizienten, Weyl-Gruppe genannt, ausgewählt wird.

5. Sendeverfahren nach Anspruch 1, **dadurch gekennzeichnet, dass** der Abbildungsschritt mindestens acht das Codewort c bildende Bits ($c_0$, $c_1$, $c_2$, ..., $c_7$) in einer Abbildungsmatrix A verteilt und die folgenden Teilschritte enthält:

- Abbildung der Paare ($c_2$,$C_3$), ($c_4$,$c_5$) und ($c_6$,$c_7$) gemäß der Gray-Abbildung, was ein Triplet von komplexen Symbolen ($s_0$, $s_1$, $s_2$) liefert;
- Abbildung des Paars ($c_0$, $c_1$), indem die komplexe Zahl 0 an der Stelle ($2c_0$+1) im Triplet von komplexen Symbolen eingefügt wird, was ein Quadrupel komplexer Symbole liefert;
- Verteilung der komplexen Symbole des Quadrupels in einer umkehrbaren Abbildungsmatrix A.

6. Sendeverfahren nach Anspruch 5, **dadurch gekennzeichnet, dass** der Abbildungsschritt außerdem jeweils n Verteilungsschritte von mindestens acht das Codewort c bildenden Bits in mindestens n Abbildungsmatrizen $A_n$, wobei n eine ganze Zahl ungleich Null ist, enthält, und dass das Verfahren einen Schritt der Berechnung einer globalen zu sendenden Abbildungsmatrix enthält, die der Summe

$$A + \sum_{i=1}^{n} \frac{A_i}{2^i}$$

entspricht.

7. Vorrichtung zum Senden einer mindestens ein Ausgangswort x enthaltenden Ausgangsbitfolge in einem Übertragungskanal,
**dadurch gekennzeichnet, dass** sie für mindestens ein Ausgangswort Folgende anwendet:

- Einrichtungen zur Fehlerkorrekturcodierung des Ausgangsworts x, die ein Codewort c liefern;
- Einrichtungen zur Verteilung der das Codewort c bildenden Bits in mindestens zwei Abbildungsmatrizen genannten Matrizen, die umkehrbar sind und ein Einzigkeitskriterium der Unterdrückung des dem Codewort c zugeordneten Syndroms beachten, so dass ein einziges Codewort entsprechend einem einzigen Paar von Abbildungsmatrizen das dem Codewort zugeordnete Syndrom unterdrückt, wobei die Abbildungsmatrizen die nützliche Information des Ausgangsworts x tragen, wobei die Verteilungseinrichtungen Matrixabbildungseinrichtungen genannt werden und eine eineindeutige Entsprechung zwischen den Bits des Codeworts c und den mindestens zwei Abbildungsmatrizen anwenden;
- Einrichtungen zum aufeinanderfolgenden Senden der mindestens zwei Abbildungsmatrizen.

8. Verfahren zum Empfang einer gesendeten Bitfolge nach Durchgang der gesendeten Bitfolge durch einen Übertragungskanal, das eine rekonstruierte Bitfolge liefert, die mindestens ein rekonstruiertes Wort enthält,
wobei die gesendete Bitfolge ausgehend von einer Bitfolge erhalten wird, die mindestens ein Ausgangswort x enthält, das vor dem Senden für mindestens ein Ausgangswort x die folgenden Schritte erfahren hat:

- Fehlerkorrekturcodierung des Ausgangsworts x, was ein Codewort c liefert;
- Verteilung der das Codewort c bildenden Bits in mindestens zwei Abbildungsmatrizen genannten Matrizen, die umkehrbar sind und ein Einzigkeitskriterium der Unterdrückung des dem Codewort c zugeordneten Syndroms beachten, wobei die Abbildungsmatrizen die nützliche Information des Ausgangsworts x tragen, wobei der Verteilungsschritt Matrixabbildungsschritt genannt wird und eine eineindeutige Entsprechung zwischen den Bits des Codeworts c und den mindestens zwei Abbildungsmatrizen anwendet;
- aufeinanderfolgendes Senden der mindestens zwei Abbildungsmatrizen,
**dadurch gekennzeichnet, dass** das Empfangsverfahren für mindestens zwei empfangene Matrizen die folgenden Schritte enthält:

- Identifikation (81) von mindestens zwei umkehrbaren Decodiermatrizen mit komplexen Koeffizienten, die es ermöglichen, ein Minimierungskriterium der Norm des dem Codewort c zugeordneten Syndroms zu beachten, wobei die gesendeten Abbildungsmatrizen so ausgewählt werden, dass ein einziges Paar von Decodiermatrizen es ermöglicht, die Norm des Syndroms zu minimieren;
- Bestimmung (82) des rekonstruierten Worts ausgehend von den identifizierten Decodiermatrizen.

**9.** Empfangsverfahren nach Anspruch 8, **dadurch gekennzeichnet, dass** das Minimierungskriterium der Norm des dem Codewort c zugeordneten Syndroms sich für zwei empfangene Matrizen Y(t) und $Y$(t+1) und zwei Decodiermatrizen $M_a$ und $M_b$ folgendermaßen schreibt:

$$\left(\widehat{M}_a, \widehat{M}_b\right) = Arg \min_{(M_a, M_b)} \|Y(t).M_a^{-1} - Y(1+t).M_b^{-1}\|$$

wobei $\|\cdot\|$ die Norm einer Matrix darstellt.

**10.** Empfangsverfahren nach Anspruch 8, **dadurch gekennzeichnet, dass** es vor dem Schritt der Bestimmung des rekonstruierten Worts die folgenden Schritte für eine Fehlerkorrekturcodierung enthält, die einen als Trellis dargestellten Faltungscode anwenden:

- Bestimmung der Metriken der Zweige der Abschnitte des Trellis des Faltungscodes, wobei jeder Zweig durch eine der Decodiermatrizen gekennzeichnet wird;
- Anwenden des Viterbi-Decodieralgorithmus, ausgehend von den Zweig-Metriken, der Zustands-Metriken liefert.

**11.** Empfangsverfahren nach Anspruch 10, **dadurch gekennzeichnet, dass** eine Metrik $\gamma_t(M_b)$ eines der durch eine Decodiermatrix $M_b$ gekennzeichneten Zweige durch die folgende Gleichung für drei empfangene Matrizen $Y(t-1)$, Y(t) und Y(t+1) und drei Decodiermatrizen $M_a$, $M_b$ und $M_c$ bestimmt wird:

$$\gamma_t(M_b) = \min_{(M_a, M_b)} \lambda \|Y(t-1).M_a^{-1} - 2Y(t).M_b^{-1} + Y(t+1).M_c^{-1}\|$$
$$+ \mu \|Y(t) - \widehat{H}'(t).M_b\|,$$

wobei $\lambda$ und $\mu$ adaptive Gewichtungskoeffizienten sind und $\widehat{H}'(t)$ ein Schätzwert der Kanalmatrix nach Konvergenz des Viterbi-Decodieralgorithmus ist, so dass gilt:

$$\widehat{H}'(t) = (Y(t-1).M_a^{-1} + Y(t).M_b^{-1} + Y(t+1).M_c^{-1})/3\,.$$

**12.** Vorrichtung zum Empfangen einer gesendeten Bitfolge nach Durchgang der gesendeten Bitfolge durch einen Übertragungskanal, was eine rekonstruierte Bitfolge liefert, die mindestens ein rekonstruiertes Wort enthält, wobei die gesendete Bitfolge ausgehend von einer Bitfolge erhalten wird, die mindestens ein Ausgangswort x enthält, für das vor dem Senden Folgende angewendet wurden:

- Einrichtungen zur Fehlerkorrekturcodierung des Ausgangsworts x, die ein Codewort c liefern;
- Einrichtungen zur Verteilung der das Codewort c bildenden Bits in mindestens zwei Abbildungsmatrizen genannten Matrizen, die umkehrbar sind und ein Einzigkeitskriterium der Unterdrückung des dem Codewort c zugeordneten Syndroms beachten, wobei die Abbildungsmatrizen die nützliche Information des Ausgangsworts x tragen, wobei die Verteilungseinrichtungen Matrixabbildungseinrichtungen genannt werden und eine eineindeutige Entsprechung zwischen den Bits des Codeworts c und den mindestens zwei Abbildungsmatrizen anwenden;
- Einrichtungen zum aufeinanderfolgenden Senden der mindestens zwei Abbildungsmatrizen, **dadurch gekennzeichnet, dass** die Empfangsvorrichtung für mindestens zwei empfangene Matrizen Folgende enthält:

- Einrichtungen zur Identifikation von mindestens zwei umkehrbaren Decodiermatrizen mit komplexen Koeffizienten, die es ermöglichen, ein Minimierungskriterium der Norm des dem Codewort c zugeordneten Syndroms zu beachten, wobei die gesendeten Abbildungsmatrizen so ausgewählt werden, dass ein einziges Paar von Decodiermatrizen es ermöglicht, die Norm des Syndroms zu minimieren;
- Einrichtungen zur Bestimmung des rekonstruierten Worts ausgehend von den identifizierten Decodiermatrizen.

13. Computerprogramm, das Anweisungen zur Anwendung des Verfahrens nach Anspruch 1 oder Anspruch 8 aufweist, wenn das Programm von einem Prozessor ausgeführt wird.

**Claims**

1. Method of transmitting a source binary sequence including at least one source word $x$ in a transmission channel, **characterised in that** it includes the following steps, for at least one source word:

   - error corrector coding (10) of said source word $x$, delivering a code word $c$;
   - distribution (11) of the bits constituting said code word $c$ into at least two matrices referred to as mapping matrices, which can be inverted and comply with a criterion of uniqueness of the cancellation of the syndrome associated with said code word $c$ so that a single code word corresponding to a single pair of mapping matrices cancels the syndrome associated with said code word, said mapping matrices carrying the payload information of the source word $x$, said distribution step being referred to as a matrix mapping step and employing a one-to-one correspondence between the bits of said code word c and said at least two mapping matrices;
   - successive transmission (12) of said at least two mapping matrices.

2. Transmission method according to Claim 1, **characterised in that** said uniqueness criterion of the cancellation of the syndrome is written in the following manner, for a matrix mapping step delivering two matrices $M_\alpha$ and $M_\beta$ to be sent associated with said code word $c$:

$$M_\alpha.M_a^{-1} - M_\beta.M_b^{-1} = 0\,,$$

   where $(M_\alpha, M_\beta)$ is a unique pair of matrices corresponding to said code word $c$ in a constant transmission channel perfect case.

3. Transmission method according to Claim 1, **characterised in that** said mapping step includes a sub-step of permutation of said bits of said code word $c$ prior to said distribution of said bits constituting said code word $c$.

4. Transmission method according to Claim 1, **characterised in that** said mapping step distributes at least four bits $(c_0, c_1, c_2, c_3)$ constituting said code word $c$ into a mapping matrix and **in that** said mapping matrix is selected in a known set of matrices that can be inverted with complex coefficients, denoted a Weyl group.

5. Transmission method according to Claim 1, **characterised in that** said mapping step distributes at least eight bits $(c_0, c_1, c_2, ... c_7)$ constituting said code word $c$ into a mapping matrix A and includes the following substeps:

   - mapping in accordance with the Gray mapping of the pairs $(c_2, c_2)$, $(c_4, c_5)$ and $(c_6, c_7)$ delivering a triplet of complex symbols $(s_0, s_1, s_2)$ ;
   - mapping of the pair $(c_0, c_1)$ by inserting the complex number 0 at position $(2c_0 + 1)$ in said triplet of complex symbols delivering a quadruplet of complex symbols;
   - distribution of said complex symbols of said quadruplet into a mapping matrix $A$ that can be inverted.

6. Transmission method according to Claim 5, **characterised in that** said mapping step further includes $n$ steps of distribution of at least eight bits constituting said code word $c$, respectively into at least $n$ mapping matrices $A_n$, where $n$ is a non-zero integer, and **in that** said method includes a step of calculating a global mapping matrix to be sent corresponding to the sum $\mathcal{I}$

7.  Device for transmitting a source binary sequence including at least one source word *x* in a transmission channel, **characterised in that** it employs, for at least one source word:

    - means for error corrector coding of said source word *x*, delivering a code word *c*;
    - means for distribution of the bits constituting said code word *c* into at least two matrices referred to as mapping matrices, which can be inverted and comply with a criterion of uniqueness of the cancellation of the syndrome associated with said code word *c* so that a single code word corresponding to a single pair of mapping matrices cancels the syndrome associated with said code word, said mapping matrices carrying the payload information of the source word *x*, said distribution means being referred to as matrix mapping means and employing a one-to-one correspondence between the bits of said code word *c* and said at least two mapping matrices;
    - means for successive transmission of said at least two mapping matrices.

8.  Method of receiving a transmitted binary sequence, after said transmitted binary sequence has passed through a transmission channel, delivering a reconstructed binary sequence including at least one reconstructed word, said transmitted binary sequence being obtained from a binary sequence including at least one source word *x*, having been subjected prior to transmission to the following steps, for at least one source word *x*:

    - error corrector coding of said source word *x*, delivering a code word *c*;
    - distribution of the bits constituting said code word c into at least two matrices referred to as mapping matrices, which can be inverted and comply with a criterion of uniqueness of the cancellation of the syndrome associated with said code word *c*, said mapping matrices carrying the payload information of the source word *x*, said distribution step being referred to as a matrix mapping step *and* employing a one-to-one correspondence between the bits of said code word *c and* said at least two mapping matrices;
    - successive transmission of said at least two mapping matrices,

    **characterised in that** said receiving method includes the following steps, for at least two received matrices:

      - identification (81) of at least two decoding matrices that can be inverted with complex coefficients making it possible to comply with a criterion of minimisation of the norm of the syndrome associated with said code word *c*, the mapping matrices sent being selected so that a single pair of decoding matrices makes it possible to minimise the norm of the syndrome;
      - determination (82) of said reconstructed word on the basis of said identified decoding matrices.

9.  Receiving method according to Claim 8, **characterised in that** said criterion of minimisation of the norm of the syndrome associated with said code word *c* is written in the following manner for two received matrices *Y(t)* and *Y(t+1)* and two decoding matrices *M$_a$* and *M$_b$*:

$$(\hat{M}_a, \hat{M}_b) = Arg \min_{(M_a, M_b)} \left\| Y(t).M_a^{-1} - Y(t+1).M_b^{-1} \right\| \ ,$$

where $\|\cdot\|$ represents the norm of a matrix.

10. Receiving method according to Claim 8, **characterised in that** it includes, prior to said step of determination of said reconstructed word, the following steps, for an error corrector code employing a convolutional code represented in trellis form:

    - determination of the metrics of the branches of the sections of said trellis of said convolutional code, each branch being labelled by one of said decoding matrices;
    - execution of the Viterbi decoding algorithm, on the basis of said branch metrics, delivering state metrics.

11. Receiving method according to Claim 10, **characterised in that** a metric $\gamma_t(M_b)$ of one of said branches labelled by a decoding matrix *M$_b$* is determined by the following equation, for three received matrices *Y(t-1),, Y(t)* and *Y(t+1)* and three decoding matrices *M$_a$*, *M$_b$* and *M$_c$* :

$$\gamma_t(M_b) = \min_{(M_a, M_c)} \lambda \left\| Y(t-1).M_a^{-1} - 2Y(t).M_b^{-1} + Y(t+1).M_c^{-1} \right\| + \mu \left\| Y(t) - \hat{H}'(t).M_b \right\|,$$

where $\lambda$ and $\mu$ are adaptive weighting coefficients and $\hat{H}'(t)$ is an estimate of the channel matrix after convergence of the Viterbi decoding algorithm so that:

$$\hat{H}'(t) = \left( Y(t-1).M_a^{-1} + Y(t).M_b^{-1} + Y(t+1).M_c^{-1} \right)/3 \, .$$

12. Device of receiving a transmitted binary sequence, after said transmitted binary sequence has passed through a transmission channel, delivering a reconstructed binary sequence including at least one reconstructed word, said transmitted binary sequence being obtained from a binary sequence including at least one source word $x$, for which there have been used prior to transmission:

- means for error corrector coding of said source word $x$, delivering a code word $c$;
- means for distribution of the bits constituting said code word $c$ into at least two matrices referred to as mapping matrices, which can be inverted and comply with a criterion of uniqueness of the cancellation of the syndrome associated with said code word $c$, said mapping matrices carrying the payload information of the source word $x$, said distribution means being referred to as matrix mapping means and employing a one-to-one correspondence between the bits of said code word $c$ and said at least two mapping matrices;
- means for successive transmission of said at least two mapping matrices,

**characterised in that** said receiving device includes, for at least two received matrices:

- means for identification of at least two decoding matrices that can be inverted with complex coefficients making it possible to comply with a criterion of minimisation of the norm of the syndrome associated with said code word $c$, the mapping matrices sent being selected so that a single pair of decoding matrices makes it possible to minimise the norm of the syndrome;
- means for determination of said reconstructed word on the basis of said identified decoding matrices.

13. Computer program including instructions for execution of the method according to Claim 1 or Claim 8 when said program is executed by a processor.

Fig. 1

Fig. 2

Fig. 3a

Fig. 3b

Fig. 4

Fig. 5a

$M_{a_0}$     $s_{t-1}$     $M_b$     $s_t$     $M_{c_0}$

$M_{a_1}$     $M_{c_1}$

$M_{a_2}$     $M_{c_2}$

$M_{a_3}$     $M_{c_3}$

## Fig. 5b

60     61     12

$x_0^3$     CODE     $c_0^7$     $M$     $M_\alpha$     Tx

## Fig. 6a

$i\mathbb{R}$

$\mathbb{R}$

## Fig. 6b

Fig. 6c

Fig. 7a

Fig. 7b

Fig. 7c

Fig. 8

Fig. 9a

Fig. 9b

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **DE CHANG-KYUNG SUNG.** Quasi orthogonal STBC with iterative decoding in bit interleaved coded modulation. *VTC,* 2004, 1323-1327
- **M.S. HASSAN ; K. AMIS.** Turbo-Product Codes Decoding for Concatenated Space-Time Error-Correcting Codes. *20th International Symposium PIMRC'2009,* 13 Septembre 2009, 1049-1053
- **DE H.BÖLCKEI ; M. BORGMANN.** Codes Design for Non-Coherent MIMO-OFDM Systems. *Allerton Conference,* 2002, 237-246
- **B.L. HUGHES.** Differential Space-Time Modulation. *IEEE transactions on Information Theory,* Novembre 2000, vol. 46 (7), 2567-2578
- **H. WEYL.** The Classical Groups. Princeton University Press, 1946
- **F.J. MACWILLIAMS ; N.J.A. SLOANE.** The theory of error-correcting codes. North-Holland, Amsterdam, 1977
- **CLAUDE BERROU et al.** Codes et turbocodes. Springer, 2007
- **PILLAI, J.N. ; MNENEY, S.H.** A review on issues related to the implementation of turbo codes and space-time trellis codes. *AFRICON, 2004. 7th AFRICON Conférence in Africa Volume: 1 Publication Year,* 2004, vol. 1, 121-126
- Low Complexity Tail-Biting Trellises of Self-Dual Codes of Length 24, 32 and 40 over GF(4) and Z4 of Large Minimun Distance. **E. CADIC ; J.C. CARLACH ; G. OLOCCO ; A. OTMANI ; J.P. TILLICH.** Proceedings of the 14th International Symposium on Applied Algebra, Algebraic Algorithms and Error-Correcting Codes (AAECC'14), Melbourne (Australia). Novembre 2001, 57-66